(19) Europäisches Patentamt
European Patent Office
Office européen des brevets

(11) EP 1 493 562 A2

(12) EUROPEAN PATENT APPLICATION

(43) Date of publication:
**05.01.2005 Bulletin 2005/01**

(51) Int Cl.7: **B41C 1/10**, G03F 7/30

(21) Application number: **04015649.9**

(22) Date of filing: **02.07.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **04.07.2003 JP 2003191754**

(71) Applicant: **Fuji Photo Film Co., Ltd.**
**Kanagawa (JP)**

(72) Inventor: **Ohnishi, Hironori**
**Yoshida-Cho, Haibara-Gun, Shizuoka (JP)**

(74) Representative: **HOFFMANN - EITLE**
**Patent- und Rechtsanwälte**
**Arabellastrasse 4**
**81925 München (DE)**

# (54) A method for developing a lithographic printing plate precursor

(57) The present invention relates to a method for developing a lithographic printing plate precursor suitable for applying a positive-working lithographic printing plate precursor for infrared laser which is used for direct plate making. Especially, the present invention relates to a method for developing a lithographic printing plate precursor by using an alkaline developing solution containing a development inhibitor, said lithographic printing plate precursor comprising a substrate and an image forming layer thereon which comprises an alkali soluble resin, said method comprising the steps of: (1) predetermining a relationship α between the concentration of said development inhibitor and the alkalinity of said alkaline developing solution under appropriate development conditions; (2) measuring both said concentration of said development inhibitor and said alkalinity of said alkaline developing solution at the time of developing said precursor; and (3) controlling said concentration of said development inhibitor and/or said alkalinity in order to satisfy said relationship α.

EP 1 493 562 A2

## Description

### FIELD OF THE INVENTION

The present invention relates to a method for developing a lithographic printing plate precursor, and a developping system for a lithographic printing plate precursor. Especially, a method for developing such a precursor suitable for a positive-working lithographic printing plate for an infrared laser which is capable of achieving direct plate making, that is, making a printing plate directly by a scanning exposure based on digital signals from computers or the like.
The disclosure of Japanese Patent Application No. 2003-191754 filed July 4, 2003 including specification, drawings and claims is incorporated herein by reference in its entirety.

### BACKGROUND OF THE INVENTION

Generally, a photosensitive lithographic printing plate precursor, especially, a photosensitive positive-working lithographic printing plate precursor, contains an alkali soluble resin as a major component. When the photosensitive positive-working lithographic printing plate precursor is imagewise-exposed, a portion of a resulting exposed image forming layer material, which corresponds to a non-image region, is dissoluble in alkali. The resulting exposed image forming layer material is solved in a developing solution and removed to form an image region, i.e. a non-exposed image forming layer. The developing solution usually contains an alkaline component for dissolving an exposed image forming layer material. In a development process, the alkaline component is consumed during processing of the processed photosensitive positive-working lithographic printing plate precursor. The more the amount of the processed photosensitive positive-working lithographic printing plate precursor increases, the more the alkaline component is consumed, whereby the effect of the image forming layer material dissolving is decreased.
The alkaline developing solution tends to absorb a carbon dioxide gas in the air. The alkaline component is also consumed by this absorption. The amount of the processed photosensitive positive-working lithographic printing plate precursor has no relation to the effect of dissolving the image forming layer material. This effect is decreased with time.
When the effect of dissolving the image forming layer material dissolving is decreased, it is difficult to remove a portion of the exposed image forming layer material from a substrate of a printing plate, whereby image lines are broadened and a dot pattern becomes narrower. If this dissolving effect is decreased more, a residual membrane will be formed on the substrate.
In order to supply the consumed alkali, a supplement having high alkalinity is added to the developing solution to maintain it at a constant pH, whereby the developing ability is maintained. Further, a certain activity of the developing solution is maintained by adjusting electric conductivity of the developing solution, whereby the developing ability is maintained (cf. Japanese Patent Kokai No. 61-61164, which is incorporated herein by reference in its entirety.).
On the other hand, as for a lithographic printing plate precursor, especially a photosensitive positive-working lithographic printing plate precursor for an infrared laser, a technique for adding a development inhibitor to the developing solution in order to inhibit dissolution of a non-exposed image forming layer, and in order to differentiate solubility between an exposed region and a non-exposed region, is proposed (cf. Japanese Patent Kokai No. 2001-174981, which is incorporated herein by reference in its entirety.). When this developing solution is used in a development process, the development inhibitor reacts with the dissolved image forming layer material. Therefore, the greater the amount of lithographic printing plate precursor developed, the greater the amount of the development inhibitor consumed. The greater the amount of the photosensitive positive-working lithographic printing plate precursor developed, the greater the amount of the development inhibitor consumed, whereby the effect of inhibiting dissolution of non-exposed image forming layer is decreased. As a result, a portion of a non-exposed image forming layer which portion should not be dissolved is easy to dissolve, whereby image lines are broadened and a dot pattern becomes narrower. A higher developing ability causes a portion of an image region to be peeled off, and a printable amount to be reduced.
In such a case, a stable development process only for keeping the alkalinity of the developing solution at a certain level cannot be carried out by the conventional process. An alternative technique has been proposed to solve such a problem, where two or more supplements having different concentrations of the development inhibitor based on a developing amount from each other are added in order to keep the alkalinity and concentration of the development inhibitor at a certain level (cf. Japanese Patent Kokai No. 2002-318454). However, the technique has disadvantages in that two or more supplements are required and that a supplement device is complex.

### SUMMARY OF THE INVENTION

Accordingly, an object of the present invention is to provide a method for developing a lithographic printing plate precursor which has a good sensitivity and development latitude at a time of forming an image, and which can

form superior image stably even if the development process is carried out for a long time. Especially, an object of the present invention is to provide a method for developing a lithographic printing plate precursor suitable for applying a positive-working lithographic printing plate precursor for infrared laser which is used for direct plate making.

The inventors of the present invention has conducted various studies to accomplish the foregoing objects, and has had an interest in that it is important to keep balance between the concentration of the development inhibitor and the alkalinity through a development process in order to obtain appropriate developing ability, i.e. ability of a developing solution for completely dissolving a non-image region and not dissolving an image region. The inventors of the present invention has found a method for developing a lithographic printing plate precursor by using an alkaline developing solution containing a development inhibitor, said lithographic printing plate precursor comprising a substrate and an image forming layer thereon which comprises an alkali soluble resin,
said method comprising the steps of:

(1) predetermining a relationship α between the concentration of said development inhibitor and the alkalinity of said alkaline developing solution under appropriate development conditions;
(2) measuring both said concentration of said development inhibitor and said alkalinity of said alkaline developing solution at the time of developing said precursor; and
(3) controlling said concentration of said development inhibitor and/or said alkalinity in order to satisfy said relationship α.

BRIEF DESCRIPTION OF DRAWINGS

Fig. 1-A is a graph showing the relationship α 1-A between the concentration of a developing inhibitor and alkali strength for realizing a suitable developing property obtained with lithographic printing plate precursor 1.
Fig. 1-B is a graph showing the relationship α 1-B between the concentration of a developing inhibitor and alkali strength for realizing a suitable developing property obtained with lithographic printing plate precursor 3.
Fig. 2 is a graph showing the relationship between the alkalinity and the change in the electroconductivity observed when carbon dioxide was introduced in developer a1 and replenisher b1 and also the when lithographic printing plate precursor 1 was dissolved in developer a1 and replenisher b1.
Fig. 3-A is a graph showing the relationship α 2-A between the concentration of a developing inhibitor and alkali strength for realizing a suitable developing property obtained with lithographic printing plate precursor 1.
Fig. 3-B is a graph showing the relationship α 2-B between the concentration of a developing inhibitor and alkali strength for realizing a suitable developing property obtained with lithographic printing plate precursor 3.
Fig. 4 is a graph showing the relationship between the alkalinity and the change in the electroconductivity observed when carbon dioxide was introduced in developer a2 and replenisher b2 and also the when lithographic printing plate precursor 1 was dissolved in developer a2 and replenisher b2.
Fig. 5 is a graph showing the relationship between the processed amount and change in the concentration of the inhibitor.

DETAILED DESCRIPTION OF THE INVENTION

The method for developing a lithographic printing plate precursor, and the developping system for a lithographic printing plate precursor according to the present invention will now be explained in detail.

(1) Developing Method

The present invention is applicable to a method for preparing a lithographic printing plate which comprises the steps of imagewise-exposing a lithographic printing plate precursor, then developing the imagewise-exposed precursor, washing it with water and rinsing, desensitizing and drying it. Especially, the present invention is directed to a method for developing a lithographic printing plate precursor comprising the steps of

(1) predetermining the relationship α between the concentration of a development inhibitor in an alkaline developer capable of showing an appropriate developing ability and the alkalinity thereof;
(2) measuring both the concentration of the development inhibitor in the alkaline developer and the alkalinity thereof during developing the precursor; and
(3) controlling the concentration of the development inhibitor in the alkaline developer and/or the alkalinity thereof so that the relationship α is satisfied.

The foregoing steps (1) to (3) will now be explained in detail below:

(1-1) As for the step (1): predetermination of the relationship α between the concentration of a development inhibitor in an alkaline developer capable of showing an appropriate developing ability and the alkalinity thereof:

(1-1-1) As to the Appropriate Developing Ability:

The relationship α between the concentration of the development inhibitor in the alkaline developer capable of showing an appropriate developing ability and the alkalinity thereof should preliminarily be determined prior to the practical development of the imagewise-exposed lithographic printing plate precursor. The concentration of the development inhibitor is reduced in proportion to the throughput rate of the lithographic printing plate precursor and the inhibitor excessively dissolves the material for the image-forming layer or the inhibitor positively acts on the developing ability of the precursor. On the other hand, the alkalinity is reduced in proportion to the throughput rate of the precursor and with the elapse of time and reduces the solubility of the material for the image-forming layer in the developer or the alkalinity negatively acts on the developing ability. For this reason, one of the objects of the present invention is to ensure an appropriate developing ability by the establishment of a well-balanced solubility of the material for the image-forming layer in the developer

The term "appropriate developing ability" herein used means an ability of forming images capable of being used as a lithographic printing plate without any trouble. If the developing ability is too high, fine lines and small dots are further reduced, any desired printed matter cannot be obtained, a part of the layer to be removed remains on the substrate and this in turn becomes a cause of staining of the resulting printed matters. In addition, the judgment of whether the developing ability is appropriate or not can be inspected by, for instance, a method in which a lithographic printing plate precursor is imagewise-exposed to light rays having a specific beam strength and then observing the image area and the non-image area of the developed precursor with naked eyes or a microscope; a method which comprises the step of determining the density changes of the image area before and after the development thereof using an image-densitometer (such as GRETAG D19C Reflection Densitometer (available from Gretague-Macbeth Company)); or a method which determines whether the percent dot area of half-tone dot portions is appropriate or not using the foregoing image-densitometer.

(1-1-2) As to the Relationship α

In the present invention, the relationship α between the concentration of a development inhibitor in an alkaline developer and the alkalinity thereof is in advance determined so that the developer can show such an appropriate developing ability. As a method for determining such a relationship α , there may be listed, for instance, one in which the relationship is independently determined for each lithographic printing plate precursor to be developed.

Such a method for independently determining the relationship for each lithographic printing plate precursor to be developed comprises, for instance, various kinds of developers having different development inhibitor concentrations and alkalinities and developing lithographic printing plate precursors with these different developers to thus determine the relationship (the relationship α) between the concentration of the development inhibitor in the alkaline developer and the alkalinity thereof, which can ensure the desired developing ability. The relationship may vary depending on the materials used as the development inhibitors or the kinds of the lithographic printing plate precursors used and therefore, it is suitable to experimentally determine the same individually.

(1-1-3) As to the Development Inhibitor Concentration in the Alkaline Developer

As means for the determination of the development inhibitor concentration in the alkaline developer, there may be listed a variety of methods and specific examples thereof are as follows:

(a) A means for directly determining the development inhibitor concentration;
(b) A means for indirectly determining the development inhibitor concentration from the concentration of an alkali-soluble resin in the alkaline developer;
(c) A means for indirectly determining the development inhibitor concentration from the throughput rate of the lithographic printing plate precursor; and a combination thereof.

These means will be described below in detail.

Examples of the means (a) for directly determining the development inhibitor concentration include those comprising the step of determining the development inhibitor concentration using a device selected from the group consisting of electrochemical analyzers such as ion selective electrodes; spectrophotometric analyzers such as ultraviolet-visible spectrophotometers; chromatography devices such as liquid chromatography and gas chromatography; foaming ability-determining devices for the determination of the foaming ability of a developer; and combinations thereof. The developer to be inspected is sampled by, for instance, a circulation pump through a pipe disposed within a developing tank.

An electrochemical analyzer usable herein is desirably one for determining the development inhibitor concentration according to the potentiometric measurement using a working electrode, a reference electrode and an auxiliary electrode. The working electrode usable herein may be an ion selective electrode prepared by the adhesion of a plasticized polyvinyl chloride film to a glass film, a solid film or an ionexchange film. Such electrodes usable herein include, for instance, those disclosed in the following literatures: Anal. Sci., 1987, 3: 121; and Analytic Chemistry, 1990, 39: 520. Moreover, additional steps such as a step of neutralizing the developer, a step for the addition of a metal ion solution and/or a step for titrating with a precipitator may likewise be used in combination for the improvement of the measuring accuracy.

The spectrophotometric analyzer usable herein may be one for determining the absorbance of the developer using an ultraviolet-visible spectrophotometer to thus determine the development inhibitor present in the developer. Further, additional steps such as a step of adding a dye capable of being adsorbed on the development inhibitor and/or a step for bringing the inhibitor into contact with an organic solvent for the improvement of the measuring accuracy.

The chromatography usable herein may be a variety of combinations of various kinds of separating means using a column such as a gas chromatography or liquid chromatography column with a highly sensitive detection method such as a thermal conductivity detector, a UV absorption detector, a differential refractive index detector, an electrical conductivity detector, mass spectrometry or nuclear magnetic resonance spectroscopy and this technique can be applied to the developer directly or after bringing it into contact with an organic solvent. Examples thereof usable herein are those disclosed in J.P KOKAI 2000-5589.

The foaming ability-determining devices usable herein may be one which comprises a foaming part in which the developer is foamed; a measuring part for determining the time required for the disappearance of a predetermined amount of the foam of the developer generated in the foaming part; an operation part for calculating the concentration of a surfactant present in the developer based on the foam-disappearance time as determined in the measuring part. Examples thereof include those disclosed in J.P. KOKAI Hei 6-194311.

Among the foregoing devices, desirably used herein are those having the following constructions since they do not considerably affect the principal component of the developer and they are simple and less expensive, with an electrochemical analyzer using an ion selective electrode and a foaming ability-determining device being suitably used in the present invention.

The means (b) for indirectly determining the development inhibitor concentration from the concentration of an alkali-soluble resin in the alkaline developer makes use of the fact that the development inhibitor concentration has a correlation with the concentration of an alkali-soluble resin in the alkaline developer. When developing an imagewise-exposed lithographic printing plate precursor, the alkali-soluble resin is dissolved in the alkaline developer. The alkali-soluble resin thus dissolved in the developer reacts with the development inhibitor present therein and is thus proportionally consumed and therefore, the development inhibitor concentration can be calculated from the concentration of the alkali-soluble resin in the developer. An alkali-soluble resin is preliminarily dissolved in a developer containing a development inhibitor and then the development inhibitor concentration of the resulting liquid is determined according to the foregoing method (a) to thus experimentally determine the correlation between the dissolved amount of the resin and the development inhibitor concentration.

More specifically, methods for determining the concentration of an alkali-soluble resin present in an alkaline developer usable herein are, for instance, those for the determination of, for instance, the absorbance and viscosity of the developer, the concentration of an organic substance present therein and the concentrations of elements included in the alkali-soluble resin.

The method for the determination of the absorbance of a developer is one which comprises the step of determining the absorbance of an alkali-soluble resin in the ultraviolet-visible region to thus determine the concentration of the alkali-soluble resin present in the alkaline developer. In addition, the image-forming layer used in the lithographic printing plate precursor in general comprises, for instance, a color dye for making easy the visual discrimination of the image area from the non-image area, an infrared-absorption dye and/or a UV-absorption dye for the absorption of light rays upon the imagewise-exposure, in addition to the alkali-soluble resin. These dyes are proportionally dissolved in the developer along with the alkali-soluble resin. Accordingly, the alkali-soluble resin concentration can be determined by measuring the absorbance of such dyes in the visible, ultraviolet and/or infrared regions while making use of the fact that the concentrations of the resin and the dyes dissolved in the developer are correlated to one another. The determination of such absorbance is conducted by, for instance, introducing a developer into an optical cell, irradiating the cell with a light beam and determining the rate of the attenuation of the transmitted light. Examples of measuring devices usable herein are those disclosed in, for instance, Japanese Utility Model Application Serial Number Hei 5-47650 and J.P. KOKAI 2002-340787.

The method for the determination of the viscosity of a developer makes use of the fact that the viscosity of the developer increases as the concentration of the alkali-soluble resin dissolved in the developer increases. The viscosity is determined by, for instance, securing a viscosity- determining device to a developer tank to thus determine the viscosity of the developer. Examples of such viscosity-determining devices usable herein are a rotational viscometer such as VISCOMEX 500 (available from Prestecks (GB) Company), San-Cup Viscometer and a vibrating or oscillating viscometer.

The method for determining the concentration of organic substances present in the developer includes, for instance, (i) a method for determining the concentrations of the whole organic substances (including the alkali-soluble resin and dyes) contained in the image-forming layer dissolved in the developer and (ii) a method for determining the concentration of a material such as the alkali-soluble resin, the dye or one of other materials among the whole components of the image-forming layer dissolved in the developer. The organic substances contained in the image-forming layer are dissolved in the developer in amounts proportional to that of the alkali-soluble resin. Accordingly, the concentration of the alkali-soluble resin can be determined by measuring the concentrations of the organic substances in the developer while making use of the fact that the concentrations of the alkali-soluble resin and the organic substances dissolved in the developer are correlated with one another As the method (i), there may be used, for instance, a method which comprises the steps of adding a developer to a combustion tube to thus convert the alkali-soluble resin as an organic substance into carbon dioxide gas and then determining the concentration of the carbon dioxide using a carbon dioxide densitometer. Usable herein are devices as disclosed in, for instance, J.R KOKAI 2001-337082. Methods using, for instance, a chromatograph such as a liquid chromatograph or a gas chromatograph may be used in the method (ii). The chromatograph usable herein may be one comprising a variety of combinations of various kinds of separating means using a column such as a gas chromatography or liquid chromatography column with a highly sensitive detection means such as a UV absorption detector, an electrical conductivity detector, mass spectrometry or nuclear magnetic resonance spectroscopy and this technique can be applied to the developer directly or after bringing it into contact with an organic solvent. Examples thereof usable herein are those disclosed in J.P. KOKAI 2000-5589.

The method for determining the concentration of the elements included in the alkali-soluble resin may be one for the determination of the alkali-soluble resin concentration on the basis of the concentrations of the elements included in the resin as determined by, for instance, the method disclosed in J.P. KOKAI 2000-054090.

Among the foregoing methods, preferably used herein are devices for determining the absorbance and/or viscosity of the developer since they do not significantly affect the components of the developer other than the alkali-soluble resin and they are quite simple and less expensive.

The means (c) for the indirect determination of the development inhibitor concentration from the throughput rate of the lithographic printing plate precursor makes use of the fact that the alkali-soluble resin concentration in the alkaline developer can be determined from the throughput rate of the lithographic printing plate precursor, by analogy The concentration of the alkali-soluble resin dissolved in the alkaline developer is approximately correlated with the throughput rate of the lithographic printing plate precursor although it may somewhat vary depending on the areas of the image and non-image portions. Moreover, as has been described above in connection with (b), the concentration of the alkali-soluble resin is correlated with the concentration of the development inhibitor. Therefore, the concentration of the development inhibitor can be determined on the basis of the throughput rate of the lithographic printing plate precursor. Specifically, in order to indirectly determine the variation in the concentration of the development inhibitor from the throughput rate, the developing treatment is carried out in a developer containing a preliminarily added development inhibitor, while changing the throughput rate to determine the development inhibitor concentration according to the foregoing method (a) and to thus obtain the relation between the throughput rate and the development inhibitor concentration. More specifically, the throughput rate can be changed within the range of from 0 to 200 lithographic printing plate precursors per day to thus experimentally determine the variation in the development inhibitor concentration.

The term "throughput (rate)" used herein means the number of lithographic printing plate precursors or the area of one side of a lithographic printing plate precursor developed within a predetermined period of time, for instance, the surface area of lithographic printing plate precursors developed per day.

The throughput rate may be determined using a variety of techniques. An example thereof is a technique in which a plate-detection sensor is arranged at the inlet port of the developing zone to thus calculate the area of the plate passing through the sensor. Alternatively, it is also possible to input, in advance, the use record of the developing machine used in the past into the microcomputer of the machine.

Alternatively, if using a computer for transmitting image-information from an exposure machine or making use of such a technique for receiving the image-information from an exposure machine and calculating the image area, the image and non-image areas can separately be calculated and therefore, the amount of the alkali-soluble resin dissolved in the developer can further precisely be determined on the basis of the throughput rate of the lithographic printing plate precursor. In this case, the term "throughput (rate)" used means the area of either the imagewise-exposed or un-exposed region.

(1-1-4) As to Alkalinity of Alkaline Developer

In the present invention, the alkalinity (pH) of the developer undergoes a change depending on the throughput rate and with the elapse of time. The pH value of the developer may be determined using a commercially available pH meter. In the present invention, the pH value is preferably determined by measuring the electrical conductivity of the developer using an electrical conductivity detector in order to stably determine the pH value thereof with a high accuracy over a long period of time, even in a highly alkaline region in which the pH value logarithmically varies.

When calculating the alkalinity or the pH value from an electrical conductivity, the conductivity is greatly influenced by the concentrations of electrolytes other than those involved in the establishment of the alkalinity. The concentrations of electrolytes other than those involved in the establishment of the alkalinity may vary depending on the compositions of the developer and replenisher. Accordingly, when a replenisher is supplemented, the electrical conductivity varies depending on the rate of the substitution of the developer with the replenisher. Further the electrical conductivity is likewise influenced by the amount of the processed lithographic printing plate precursor and the carbon dioxide concentration in the environment and therefore, it is desirable that the electrical conductivity value be automatically or manually corrected for the items specified above.

Specifically, the relations between the alkalinity and the electrical conductivity observed in cases where (i) lithographic printing plate precursors are processed in the developer and replenisher and (ii) carbon dioxide is blown into the developer and replenisher are preliminarily, experimentally determined and the results are programmed in a microcomputer of the automatic developing machine. The rate of the substitution of the liquid in a developer tank with the replenisher, the carbon dioxide concentration and the like are determined by the feedback of the number of supplementation, the amount of the replenisher supplemented and the elapse of time to thus correct the relation between the electrical conductivity and the alkalinity.

The electrical conductivity of the developer can be determined by the use of, for instance, an alternating current conductivity meter, an alternating current bridge-conductivity meter or other conductivity meters.

The optimum conditions for the electric current used for the measurement and the oscillating frequency thereof in the electrical conductivity meter vary depending on, for instance, the composition of the developer, but the electric current value is preferably low to some extent from the viewpoint of the device in itself and for the prevention of any electrolysis of an aqueous developer and specifically and suitably ranges from several μ A to several hundreds mA. Moreover, the frequency of the current used suitably ranges from several hundreds Hz to several hundreds kHz while taking into consideration the relation with the electrostatic capacity components in the developer.

The conductivity value of a developer containing electrolytes depends on the temperature of the aqueous solution and it is reduced as the temperature of the solution increases. Accordingly, it is more preferred to determine the electric conductivity value using a measuring device provided with a temperature sensor and a temperature-compensation circuit. Moreover, in a device for controlling the supplementation of the developer, the temperature-compensation may likewise be carried out by converting the practically determined resistance value at a measuring temperature into an electrical conductivity value at a predetermined temperature.

The sensor may be secured to any position of an alternating current conductivity meter, an alternating current bridge-conductivity meter or other conductivity meters inasmuch as the sensor is immersed in the developer during the conductivity measurement and the AC. conductivity value of the developer can certainly be determined and it is arranged in the developer-circulation system and, in particular, it is preferably disposed in the developing tank or in the circulation pipe. Moreover, a known measuring cell can be used as the detection part, which is provided with a platinum or stainless steel electrodes.

(1-2) As to Steps for Determining Development Inhibitor Concentration in Alkaline Developer and Alkalinity Thereof during Development Treatment:

After the relationship α between the development inhibitor concentration and the alkalinity of the developer is preliminarily determined according to the procedures described above in the foregoing section (1-1), an imagewise-exposed lithographic printing plate precursor is practically treated with a developer. In the actual developing treatment, it is conducted while determining the development inhibitor concentration in the alkaline developer and the alkalinity thereof. In this connection, the development inhibitor concentration can be determined by a method similar to that used in the foregoing section (1-1-3). On the other hand, the alkalinity of the developer can be determined by a method similar to that used in the foregoing section (1-1-4). It is also possible to conduct the development while incorporating, in succession, these development inhibitor concentrations and alkalinities observed in the actual development into the development treatment, as data for the foregoing relationship α.

In the developing method of the present invention, it is possible to use an automatic developing machine for printing materials, which has widely been used for the rationalization and standardization of the plate-making operations in the fields of plate-making and printing industries. As such automatic developing machines, there may be listed, for

instance, PS Processors 900H available from Fuji Photo Film Co., Ltd. Such an automatic developing machine usually comprises a developing zone and a post-treatment zone. The developing zone in general comprises a device for conveying printing plates and a developing tank. As such developing tanks, there have been known a tank in which imagewise-exposed lithographic printing plate precursors are developed by spraying each developer pumped up on the printing plate precursors through a spray nozzle while horizontally conveying the plate; and a tank in which imagewise-exposed lithographic printing plate precursors are developed by conveying the plates in a developing tank filled with a developer while dipping the plates in the developer by the action of, for instance, submerged guide rolls. Moreover, when dip-developing lithographic printing plates, a pump may be used for the circulation of the liquid in the developing tank. The circulation of the developer would permit the uniform supply of the developer onto the plate surface.

(1-3) As to Step for Controlling Development Inhibitor Concentration in Alkaline Developer and/or Alkalinity Thereof so as to Satisfy the Foregoing Relationship $\alpha$:

The development inhibitor concentration in an alkaline developer or the alkalinity thereof is controlled so as to satisfy the relationship $\alpha$ determined according to the procedures set forth in the foregoing section (1-1). Specifically, the development inhibitor concentration in an alkaline developer and/or the alkalinity thereof which are monitored according to the procedures set forth in the foregoing section (1-2) are adjusted so that the relationship $\alpha$ can be maintained. Examples of such methods include a) a method in which a replenisher is supplemented in proportion to a predetermined amount (1 $m^2$) of the processed lithographic printing plate precursor, a predetermined operation time of the automatic developing machine or a predetermined period of suspension; and b) a method wherein the pH or electrical conductivity of the developer is monitored and a replenisher is supplemented at any time when the value monitored is reduced to the level of not more than a predetermined value. The amount of the replenisher to be supplemented may vary depending on the kind of the replenisher used or the existing state of the development, but a replenisher is supplemented once for a predetermined amount of the processed lithographic printing plate precursor ranging from 1 to 10 $m^2$ or at intervals of about 1 to 60 minutes in an amount ranging from 1 to 1000 ml and preferably about 10 to 500 ml.

Such supplementation is desirably so programmed that the supplementation of a replenisher can automatically be controlled and, for instance, the number of supplementation of a replenisher and the amount thereof to be supplemented are automatically changed. In this connection, the foregoing program can preferably automatically or manually be changed so as to be able to cope with any change in, for instance, the kinds of the developer or lithographic printing plate precursor or the atmosphere or the processing conditions such as simultaneous development of a plurality of lithographic printing plate precursors.

As has been discussed above, the development inhibitor concentration in a developer and the alkalinity thereof are in a predetermined balanced condition. For instance, desired development characteristics of a developer can be ensured at a high alkalinity when the development inhibitor concentration is high and even at a low alkalinity when the development inhibitor concentration is low. In other words, the alkalinity of the developer is not necessarily maintained at a predetermined level throughout the developing treatment and a large amount of lithographic printing plate precursors may be processed in a developing tank over a long period of time without exchanging the developer insofar as a well-balanced relation between the development inhibitor concentration in the developer and the alkalinity thereof can be maintained or ensured.

(1-4) Other Developing Methods

A lithographic printing plate precursor is imagewise-exposed to light rays according to a plate-making method such as that disclosed in, for instance, J.P. KOKAI 2000-187334. Examples of actinic light sources used in the imagewise-exposure include a mercury lamp, a metal halide lamp, a xenon lamp, a chemical lamp and a carbon arc lamp. Examples of radiant rays likewise usable herein are an electron beam, X-rays, an ion beam and infrared light rays. Examples of light sources usable herein also include g-rays, i-rays, Deep-UV rays and high density energy beams (laser beams). Examples of laser beams are helium-neon laser, argon laser, krypton laser, helium-cadmium laser and KrF excimer laser beams. In particular, in the imagewise-exposure of a heat-sensitive lithographic printing plate precursor, suitably used laser beams are solid-state lasers and semiconductor lasers which can emit light rays having wavelengths falling within the range of from near infrared to infrared region. This is because if a light-heat conversion substance included in a heat-sensitive lithographic printing plate precursor is irradiated with infrared light rays, the infrared rays are converted into heat, the solubility of a high molecular weight compound in an alkali is improved due to a structural change of the compound or the high molecular weight compound is cured. The lithographic printing plate precursor thus imagewise-exposed to light is then conveyed by an automatic developing machine and subjected to a developing treatment. Specifically, the imagewise-exposed precursor is transmitted through a developing zone, a water-washing zone (including the circulation of reserved water), a desensitization zone (a finisher zone) and a drying zone to thus develop the same.

Among them, preferred are the usual horizontally conveyed type ones provided with, for instance, a developer-spray and a brush in the developing zone and, in particular, preferably used herein are those having a dip-developing zone (a dipping type developing tank). The developing zone is equipped with a replenisher-supplementing device. Such a replenisher-supplementing device is preferably one comprising a replenisher tank, a water tank, a liquid-supply pump provided with a timer incorporated into the same, or a microcomputer having a variety of built-in programs corresponding to a precursor to be developed, a developer, a replenisher and/or evaporation of moisture, and a D/A converter. The developing temperature in the developing zone ranges from 20 to 40°C as expressed in terms of the developer temperature, preferably 22 to 35°C and more preferably 25 to 32°C. If the developing temperature is not more than 40°C, any excess development and accordingly, any film loss on the non-image area can be prevented. On the other hand, if it is not less than 20°C , any insufficient development would not be experienced. A shorter developing time is in general established in the developing zone when the developing temperature is high, while a longer developing time is established therein when the developing temperature is low. The developing time is preferably in the range of from 8 to 40 seconds and more preferably 10 to 30 seconds. If the developing time is not less than 8 seconds, sufficient development reproduction and development stability can be ensured, while if it is not more than 40 seconds, there is not observed any reduction in the productivity of the lithographic printing plate. Moreover, the developing zone may likewise be equipped with, for instance, a circulation device for stirring the liquid, a spray, a developing brush and a temperature controller.

In the water-washing zone, the lithographic printing plate thus developed is washed with a rinse liquid such as washing water and surfactant-containing water. A plurality of rinse zones may be used, which comprise different rinse liquids respectively.

In the desensitization zone, the lithographic printing plate thus treated is subjected to a post-treatment with a desensitization liquid containing gum Arabic or a starch derivative to thus prevent any staining of the non-image area of the resulting lithographic printing plat.

If unnecessary image portions (for instance, film edge marks of the original film) remain on the resulting lithographic printing plate, such unnecessary image portions should be removed or erased. The erasion of such unnecessary image portions is preferably carried out according to a method comprising the steps of applying a liquid for erasion such as that disclosed in, for instance, Japanese Examined Patent Publication (hereunder referred to as "J.P. KOKOKU") Hei 2-13293 onto the unnecessary image portions, allowing them to stand over a predetermined period of time and then washing with water, but it is also possible to use a method as disclosed in J.P. KOKAI Sho 59-174842 in which the unnecessary image portions are irradiated with actinic light rays guided by an optical fiber and then developed.

When it is intended to obtain a lithographic printing plate having higher printing durability, the lithographic printing plate thus prepared is then subjected to a burning treatment. When subjecting a lithographic printing plate to a burning treatment, the plate is preferably treated with a surface-conditioning liquid such as those disclosed in J.P. KOKOKU Nos. Sho 61-2518 and Sho 55-28062 and J.P. KOKAI Nos. Sho 62-31859 and Sho 61-159655, prior to the burning treatment.

Examples of means for treating a lithographic printing plate with a surface-conditioning liquid are a method comprising the step of applying a surface-conditioning liquid to the plate with a sponge or absorbent cotton saturated or soaked with the liquid; a method comprising the step of immersing a lithographic printing plate in a bat filled with a surface-conditioning liquid to thus apply the liquid onto the plate; and a method comprising applying a surface-conditioning liquid to a lithographic printing plate using an automatic coater. In this connection, after the application of the liquid, it is preferred to make the coated amount of the liquid uniform using a squeegee or a squeegee roller. In general, the coated amount of such a surface-conditioning liquid suitably ranges from 0.03 to 0.8 $g/m^2$ (as expressed in terms of the dry weight). The lithographic printing plate carrying the surface-conditioning liquid applied thereto is if necessary dried and then heated to a high temperature in a burning processor (such as Burning Processor "BP-1300" available from Fuji Photo Film Co., Ltd.). In this case, the heating temperature and time are preferably 180 to 300°C and 1 to 20 minutes respectively, although they vary depending on the kinds of components constituting the images of the plate.

The lithographic printing plate after the burning treatment may, if necessary, be subjected to a variety of commonly used treatments such as water washing and/or gumming treatments, but if a surface-conditioning liquid containing, for instance, a water-soluble polymeric compound is used, so-called desensitization treatments such as gumming up process can be omitted. The lithographic printing plate obtained after such treatments is then used for the preparation of a large number of printed matters by fixing the plate to an offset printing press.

(2) Alkaline Developer and Replenisher used in the Present Invention:

The developer and replenisher compositions used in the method for preparing a lithographic printing plate

precursor according to the present invention will now be described below in detail. In this connection, the terms "alkaline developer" and "developer" used in the present invention means a liquid with which the developing zone is preliminarily filled, while the term "replenisher" herein used means a liquid which is supplemented to the developer as the developing treatment proceeds. The both compositions may comprise, for instance, an alkaline component, a compound having a buffering effect, a surfactant, a water softener and an anti-foaming agent. The developer and replenisher used in the present invention contain development inhibitors and the alkalinities of these liquids and the development inhibitor concentrations thereof may satisfy the following relations, respectively: developer < replenisher; and developer ≦ replenisher.

(2-1) Alkaline Components as a Components of the Developer and Replenisher of the Invention

Examples of such alkaline components (so-called alkaline agents) included in the developer and replenisher used in the present invention include inorganic alkaline agents such as sodium tertiary phosphate, potassium tertiary phosphate, ammonium tertiary phosphate, sodium carbonate, potassium carbonate, ammonium carbonate, sodium hydrogen carbonate, potassium hydrogen carbonate, ammonium hydrogen carbonate, sodium borate, potassium borate, ammonium borate, sodium hydroxide, potassium hydroxide, ammonium hydroxide and lithium hydroxide. Examples of such alkaline components also include organic alkaline agents such as mono-methylamine, di-methylamine, trimethylamine, mono-ethylamine, diethylamine, triethylamine, mono-isopropylamine, di-isopropylamine, tri-isopropylamine, n-butylamine, mono- ethanolamine, di-ethanolamine, tri-ethanolamine, mono-isopropanolamine, di-isopropanolamine, ethylene-imine, ethylene-diamine and pyridine. Among these alkaline agents, particularly preferably used herein are sodium hydroxide and potassium hydroxide.

These alkaline agents may be used in any combination for the purpose of controlling the developing ability of the resulting liquids or the resulting developer and replenisher.

(2-2) Compounds having Buffering effects

As aqueous solutions containing compounds having buffering effects, there may be listed, for instance, a developer and a replenisher which comprise alkali silicates or non-reducing sugars and bases. In particular, preferably used herein are aqueous solutions of compounds showing its buffering action in the pH range of from 9.0 to 13.9.

(2-2-1) Alkali Silicate

The alkali silicate shows alkaline properties when dissolved in water. Specific examples thereof are alkali metal silicates such as sodium silicate, potassium silicate and lithium silicate and ammonium silicate. These alkali silicates may be used alone or in any combination. The developing ability (or performance) of the foregoing alkaline aqueous solution can easily be controlled by adjusting the mixing ratio of the components of the silicate or silicon oxide: $SiO_2$ and alkali oxide: $M_2O$ (in the formula, M represents an alkali metal or ammonium residue) and the concentration of the alkali silicate.

Among the foregoing alkaline aqueous solutions, preferably used herein are, for instance, those having a mixing ratio of silicon oxide: $SiO_2$ and alkali oxide: $M_2O$ (molar ratio $SiO_2/M_2O$) specified above ranging from 0.5 to 3.0 and more preferably 1.0 to 2.0. This is because if the mixing ratio: $SiO_2/M_2O$ is not less than 0.5, the alkalinity of the resulting alkaline aqueous solution is not significantly high and materials such as aluminum plates widely used as substrates for lithographic printing plates are never etched. On the other hand, if the mixing ratio is not more than 3.0, the resulting alkaline aqueous solution has an appropriate developing ability.

The concentration of the alkali silicate in the developer and replenisher preferably ranges from 1 to 10% by mass, more preferably 3 to 8% by mass and most preferably 4 to 7% by mass on the basis of the total mass of the alkaline aqueous solution. This is because if the concentration thereof is not less than 1% by mass, the developing ability and the processing capacity of the resulting liquid are not deteriorated, while the use of the concentration of not more than 10% by mass would prevent the generation of any precipitate and/or crystal and any gelation possibly observed when neutralizing the same upon discharge and this makes the treatment of the waste liquid easy

(2-2-2) Non-reducing Sugars

The non-reducing sugars means sugars free of any reducing ability due to the lack of any free aldehyde and/or ketone groups in the molecule and they are classified into trehalose type oligosaccharides prepared by linking reducing groups together, glycosides prepared by joining reducing groups of sugars with non-sugars, and sugar alcohols prepared by reducing sugars through hydrogenation. All of these non-reducing sugars may suitably be used in the present invention.

Examples of trehalose type oligosaccharides include saccharose and trehalose and examples of glycosides include alkyl glycosides, phenol glycosides and mustard oil glycosides.

Examples of sugar alcohols are D, L-arabitol, ribitol, xylitol, D, L-sorbitol, D, L-mannitol, D, L-iditol, D, L-talitol, dulcitol, and allodulcitol. Further, maltitol obtained by subjecting disaccharides to hydrogenation and reductants (e.g., reduced starch syrup) obtained by subjecting oligosaccharides to hydrogenation are also preferred.

Among the above-mentioned non-reducing sugars, sugar alcohols, saccharose are preferably used as the non-reducing sugars, with D-sorbitol, saccharose and reduced starch syrup being preferably employed because of their buffering action falling within an appropriate pH range.

Those non-reducing sugars may be used alone or in combination and the amount of the non-reducing sugar in the developer and the replenisher is preferably in the range of 0.1 to 30% by mass and more preferably 1 to 20% by mass.

(2-3) Development Inhibitors

As the alkaline developer for light-sensitive lithographic printing plate precursor according to the present invention, those containing development inhibitors would show higher effects. Examples of compounds having development-inhibitory effects include those represented by the following general formula (I):

$$R_1\text{-O-}(R_2\text{-O})_n\text{-H} \qquad (I)$$

In Formula (I), $R_1$ represents a hydrogen atom, a substituted or unsubstituted alkyl or alkenyl group having 1 to 30 carbon atoms, a substituted or unsubstituted aromatic hydrocarbon group having 6 to 15 carbon atoms, or a substituted or unsubstituted hetero-aromatic ring having 4 to 15 carbon atoms (in this respect, examples of substituents include alkyl and alkenyl groups having 1 to 20 carbon atoms, halogen atoms such as Br, Cl and I, aromatic hydrocarbon group having 6 to 15 carbon atoms, aralkyl groups having 7 to 17 carbon atoms, alkoxy groups having 1 to 20 carbon atoms, alkoxy-carbonyl groups having 2 to 20 carbon atoms, and acyl groups having 2 to 15 carbon atoms). $R_2$ represents a substituted or unsubstituted alkylene group having 1 to 100 carbon atoms (in this respect, examples of substituents include alkyl groups having 1 to 20 carbon atoms and aromatic hydrocarbon group having 6 to 15 carbon atoms) and n is an integer ranging from 2 to 100.

In the present invention, development inhibitors suitably used are, in particular, those having ethylene-oxy groups among others.

The moiety: $(R_2\text{-O})_n$ in Formula (I) may comprise 2 or 3 kinds of groups insofar as they fall within the range specified above. Specific examples thereof include combinations of ethylene-oxy and propylene-oxy groups; ethylene-oxy and isopropyl-oxy groups; ethylene-oxy and butylene-oxy groups; and ethylene-oxy and iso-butylene groups, which may be connected randomly or block-like shape.

The compounds represented by the general formula (I) are in general commercially available. Examples thereof commercially available include those of Formula (I) in which $R_1$ is an aliphatic hydrocarbon group such as those available from, for instance, Asahi Denka Kogyo K.K; Kao Corporation; Sanyo Chemical Industries, Ltd; New Japan Chemical Co., Ltd; Dai-ichi Kogyo Seiyaku Co., Ltd.; Takemoto Oil and Fats Co., Ltd.; Thho Chemical Industry Co., Ltd.; and Nippon Oil and Fats Co., Ltd. In addition, Examples thereof represented by Formula (I) in which $R_1$ is an aromatic hydrocarbon group such as those commercially available from, for instance, Kao Corporation; Sanyo Chemical Industries, Ltd.; Dai-ichi Kogyo Seiyaku Co., Ltd; Takemoto Oil and Fats Co., Ltd.; and Toho Chemical Industry Co., Ltd.

Specific examples of the compounds represented by the foregoing formula (I) are polyoxyethylene alkyl ethers, polyoxyethylene alkenyl ethers, polyoxyethylene phenyl ether, polyoxyethylene alkyl phenyl ethers, polyoxyethylene naphthyl ether; polyoxyethylene alkyl naphthyl ethers, polyoxyethylene anthranyl ether, polyoxyethylene alkyl anthranyl ether, polyethylene glycol or derivatives thereof, or polypropylene glycol or derivatives thereof, and Pluronic type nonionic surfactants.

Specific examples of the compounds represented by the general formula (I) also include poly(oxyethylene) octyl ether, poly(oxyethylene) lauryl ether, poly(oxyethylene) cetyl ether, poly(oxyethylene) stearyl ether, poly(oxyethylene) octyl phenyl ether, poly(oxyethylene) nonyl phenyl ether, poly(oxyethylene) dodecyl phenyl ether, poly(oxyethylene) phenyl ether, poly(oxy- ethylene) octyl naphthyl ether, poly(oxyethylene) nonyl naphthyl ether, poly(oxyethylene) dodecyl naphthyl ether, poly(oxyethylene) naphthyl ether, poly(oxyethylene) octyl anthranyl ether, poly(oxyethylene) nonyl anthranyl ether, poly(oxyethylene) dodecyl anthranyl ether, and poly(oxy- ethylene) anthranyl ether.

Specific examples of the compounds having polyethylene oxide chains used as the development inhibitors in the present invention include polyhydric alcohol type ethylene oxide adducts, for instance, ethylene oxide adducts of polyhydric alcohols such as glycerin, pentaerythritol and sorbitol; ethylene oxide adducts of aminoalcohols such as

ethylene oxide adducts of, for instance, mono-ethanolamine, di-ethanolamine and tri-ethanolamine; and ethylene oxide adducts of sugars. The term "ethylene oxide adducts" herein used includes, for instance, combinations of ethylene-oxy and propylene-oxy groups; ethylene-oxy and isopropyl-oxy groups; ethylene-oxy and butylene-oxy groups; and ethylene-oxy and iso-butylene groups, which may be connected randomly or block-like shape, in addition to those comprising ethylene oxide alone.

Further examples of the compounds having polyethylene oxide chains used as the development inhibitors in the present invention include ethylene oxide-propylene oxide adducts of alkylene diamine represented by the following formula (II):

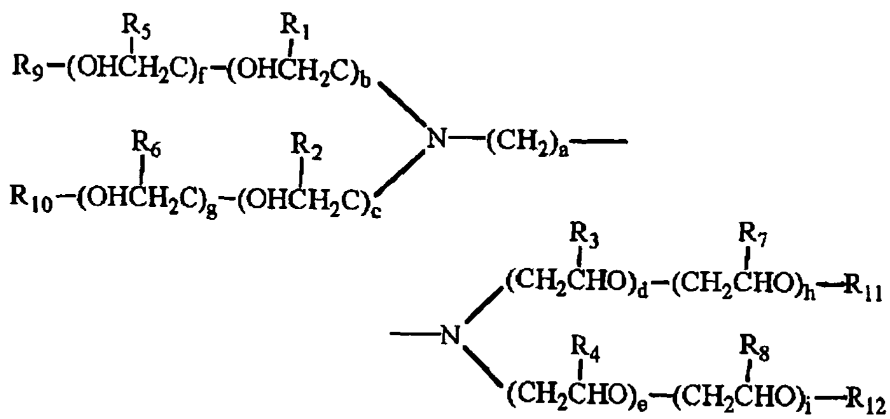

(II)

wherein $R_1$, $R_2$, $R_3$, $R_4$, $R_5$, $R_6$, $R_7$ and $R_8$ may be the same or different, and each independently represents H or $-CH_3$, and $R_9$, $R_{10}$, $R_{11}$ and $R_{12}$ may be the same or different, and each independently represents H, $-CH_3$, $-COR_{13}$ or $-CONHR_{14}$ (wherein each of $R_{13}$ and $R_{14}$ represents an alkyl, aryl, alkenyl or alkynyl group), a represents an integer of from 2 to 12, b, c, d, e, f, g, h and i may be the same or different, and each independently represents 0 or an integer of from 1 to 300, and $(b+f)(c+g)(d+h)(e+i) \neq 0$.

These compounds of Formula (II) are generally water-soluble. Such compounds are also referred to as Tetronic type nonionic surfactants.

Among the compounds of Formula (II), particularly preferred are those of Formula (II) wherein $R_1=R_2=R_3=R_4=CH_3$, $R_5=R_6=R_7=R_8=H$, $R_9=R_{10}=R_{11}=R_{12}$ =H or $-COR_{13}$ (wherein $R_{13}$ is an alkyl group), and the content of ethylene oxide moieties ranges from 40 to 80% by mass on the basis of the total mass of the molecule, the molecular weight of the propylene oxide moieties ranges from 2,000 to 5,000, and a represents an integer of from 2 to 6.

In the formula (II), the alkyl group represented by $R_{13}$ or $R_{14}$ is preferably a linear or branched alkyl group having 1 to 25 carbon atoms such as $CH_3$-, $CH_3CH_2$-, $CH_3(CH_2)_2$-, $CH_3(CH_2)_3$-, $CH_3(CH_2)_4$-, $(CH_3)_2CH(CH_2)_2$-, $CH_3CH_2CH(CH_3)$-$CH_2$-, $CH_3(CH_2)_2CH(CH_3)$-, $CH_3(CH_2)_7$-, $CH_3(CH_2)_8$-, $CH_3(CH_2)_{10}$-, $CH_3(CH_2)_{12}$-, $CH_3(CH_2)_{14}$-, $CH_3(CH_2)_{16}$-, $CH_3(CH_2)_{18}$-, $CH_3(CH_2)_{20}$-, $CH_3(CH)_2)_{22}$- and $CH_3(CH_2)_{24}$-.

In the formula (II), the aryl groups represented by $R_{13}$ and $R_{14}$ include a phenyl group, a monocyclic or bicyclic aryl groups and those substituted by linear or branched alkyl groups represented by the allowing formulas:

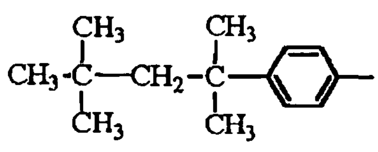 , 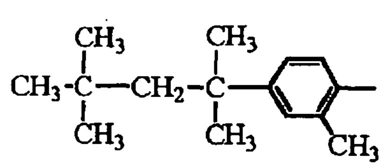 ,

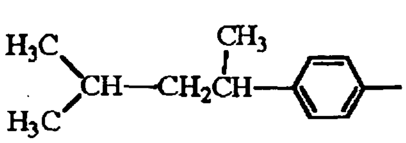 , 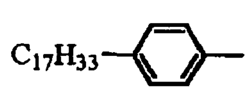 ,

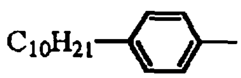 , 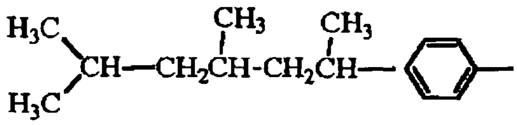 ,

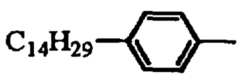 , 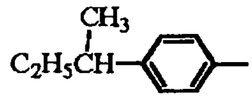 ,

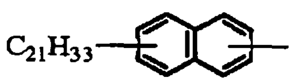 , 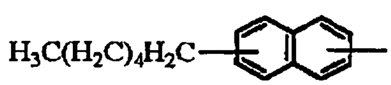 ,

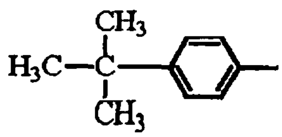

In the formula (II), the alkenyl or alkynyl groups represented by $R_{13}$ or $R_{14}$ include those having carbon atoms of from 9 to 24 such as $CH_2=CH(CH_2)_7$-, $CH_2CH_2CH=CH(CH_2)_7$-, $CH_3(CH_2)_5CH=CH$-, $CH_3(CH_2)_7CH=CH$-, $CH_3(CH_2)_5CH(OH)CH_2CH_2CH=CH(CH_2)_7$-, $CH_3(CH_2)_{10}CH=CH(C_2H)_4$-,$CH_3(CH_2)_5CH=CH(CH_2)_9$-, $CH_3(CH_2)_4CH=CHCH_2CH=CH(CH_2)_7$-, $CH_3CH_2CH=CHCH_2CH=CHCH_2CH=CH(CH_2)_7$-, $CH_3(CH_2)_3(CH=CH)_3(CH_2)_7$-, $CH_3(CH_2)_8(CH=CH)_3(CH_2)_4CO(CH_2)_2$-, $CH_3(CH_2)_7C{=}C(CH_2)_7$-, and $CH_3(CH_2)_9CH=CH(CH_2)_7$-.

Examples of the foregoing water-soluble compounds are those listed in commercial product brochures under a trade name of, for example, Tetronic which is manufactured by Asahi Denka Kogyo K.K.

The developer and the replenisher used in the present invention may comprise one or at least two compounds having polyethylene oxide chains listed above as the development inhibitor.

Among them, particularly preferably used herein are polyethylene glycol, polyethylene glycol alkyl ether, polyethylene glycol alkyl phenyl ether and ethylene oxide-propylene oxide condensate, so-called Pluronic type nonionic surfactants, and ethylene oxide-propylene oxide condensates of alkylene diamines, and so-called Tetronic type nonionic surfactants.

The concentration of the development inhibitor in the developer and replenisher used in the invention suitably ranges from 0.001 to 10.0% by mass, preferably 0.001 to 5.0% by mass and more preferably 0.005 to 1.0% by mass. If the added amount of the inhibitor is not less than 0.001% by mass, the solubility of the image area formed can sufficiently be controlled, while if it is not more than 10.0% by mass, the resulting liquid does not have an extremely high solubility-inhibition effect and therefore, the developing sensitivity is never reduced. In this connection, the concentration of the development inhibitor in the replenisher is desirably higher than that of the inhibitor in the developer.

The molecular weight of the foregoing compound used in the present invention as the development inhibitor preferably ranges from 50 to 10000, more preferably 100 to 5000 and most preferably 500 to 3500. If the molecular weight of the compound is not less than 50, the inhibitor can show its effect of inhibiting the solubilization of image areas, while if it is not more than 10000, there is not observed any reduction of the developing ability of the non-image area.

(2-4) Surfactant

The developer and the replenisher used in the invention desirably comprise an anionic surfactant in order to improve the exposed area-dissolution rate and to inhibit the generation of any scum.

Examples of anionic surfactants which can suitably be used in the present invention include alkyl aryl sulfonic acid salts such as sodium lauryl alcohol sulfate, ammonium lauryl alcohol sulfate, sodium octyl alcohol sulfate, sodium

isopropylnaphthalene sulfonate, sodium isobutyl-naphthalene sulfonate, sodium dodecylbenzene sulfonate and sodium methanitro- benzene sulfonate; sulfuric acid esters of higher alcohol having 8 to 22 carbon atoms such as sodium secondary alkyl sulfate; aliphatic alcohol phosphoric ester salts such as sodium cetyl alcohol phosphate; alkyl amide sulfonate salts such as $C_{17}H_{33}CON(CH_3CH_2CH_2SO_3Na$; sulfonate salts of bibasic aliphatic ester such as di-octyl sodium sulfosuccinate and di-hexyl sodium sulfosuccinate; hydroxyl-alkane sulfonate salts, alkane sulfonate salts, alkyl di-phenyl ether sulfonate salts; di-phenyl ether di-sulfonate salts represented by the following general formula, dialkyl sulfosuccinate salts, olefin sulfonate salts, linear alkyl benzene sulfonate salts, branched alkyl benzene sulfonate salts, alkyl naphthalene sulfonate salts, alkyl phenoxy polyoxyethylene propyl sulfonate salts, polyoxyethylene alkyl sulfophenyl ether salts, di-sodium N-alkyl sulfosuccinate mono-amide and petroleum sulfonates. Particularly preferably used herein are di-phenyl ether di-sulfonate salts represented by the following formula:

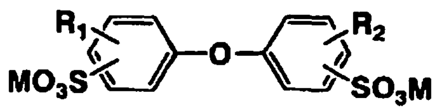

In the above formula, $R^1$ and $R^2$ independently represent a hydrogen atom or a linear or branched alkyl group and M represents a monovalent alkali metaL The alkyl group represented by $R^1$ or $R^2$ is, in particular, one having 1 to 40 and preferably from 4 to 20 carbon atoms and specific examples thereof include $nC_8H_{17}$ and $nC_{12}H_{25}$. The alkali metal represented by M may be any one, but preferred are sodium, potassium or lithium among others.

Examples of the compounds represented by the foregoing formula particularly preferably used herein are those having the following structures:

(A-1)

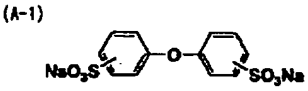

(A-2)

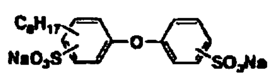

(A-3)

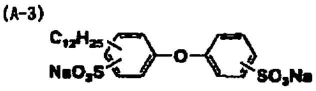

(A-4)

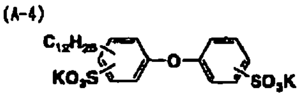

(A-5)

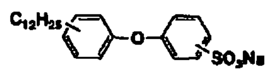

(A-6)

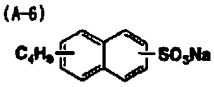

(A-7)

$C_{12}H_{25}-SO_3Na$

(A-8)

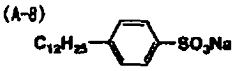

The surfactants usable in the developer and replenisher of the present invention are not restricted to the foregoing anionic ones and amphoteric surfactants, for instance, alkyl betaines such as lauryl betaine and stearyl betaine, and amino acids may likewise be used in these liquids for the improvement of the developing ability of the exposed area.

These surfactants may be used alone or in any combination. The content of these surfactants in the developer and the replenisher preferably ranges from 0.001 to 20% by mass as expressed in terms of the effective component.

(2-5) Other Additives

The developer and replenisher used in the present invention may, if necessary, comprise additives such as an organic solvent, a chelating agent, an anti-foaming agent, a dye, a pigment, a water softener and/or a preservative,

in addition to and simultaneous with the foregoing components.

(2-5-1) Organic Solvents

Examples of organic solvents used as an additive are organic carboxylic acids such as benzoic acid, phthalic acid, p-ethyl benzoic acid, p-n-propyl benzoic acid, p-isopropyl benzoic acid, p-n-butyl benzoic acid, p-t-butyl benzoic acid, p-2-hydroxyethyl benzoic acid, decanoic acid, salicylic acid and 3-hydroxy-2-naphthoic acid; isopropyl alcohol, benzyl alcohol, ethyl cellosolve, butyl cellosolve, phenyl cellosolve, propylene glycol and di-acetone alcohol.

(2-5-2) Chelating Agents

The developer and replenisher used in the present invention may comprise a chelating agent. Examples of such chelating agents are polyphosphoric acid salts such as $Na_2P_2O_7$, $Na_5P_3O_3$, $Na_3P_3O_9$, $Na_2O_4P(NaO_3P)PO_3Na_2$, and Calgon (sodium poly-metaphosphate); amino-poly- carboxylic acids such as ethylenediaminetetraacetic acid and sodium and potassium salts thereof, diethylenetriaminepentaacetic acid and sodium and potassium salts thereof, triethylene- tetramine-hexaacetic acid and sodium and potassium salts thereof, hydroxyethyl ethylene-diamine-triacetic acid and sodium and potassium salts thereof, nitrilo-triacetic acid and sodium and potassium salts thereof, 1,2-diaminocyclohexane-tetraacetic acid and sodium and potassium salts thereof, and 1,3-diamino-2-propanol-tetraacetic acid and sodium and potassium salts thereof; and organo-phosphonic acids such as 2-phosphonobutane-tricarboxylic acid-1,2,4 and sodium and potassium salts thereof, 2-phosphonobutane-tricarboxylic acid-2,3,4 and sodium and potassium salts thereof, 1-phosphonoethane-tricarboxylic acid and sodium and potassium salts thereof, 1-hydroxyethane-1,1-diphosphonic acid and sodium and potassium salts thereof, and aminotri- (methylene-phosphonic acid) and sodium and potassium salts thereof. The optimum amount of such a chelating agent may vary depending on the hardness and amount of water used, but it in general ranges from 0.01 to 5% by mass and preferably 0.02 to 1% by mass on the basis of the mass of the developer or replenisher practically used.

(2-6) Physical Properties of Developer and Replenisher

(2-6-1) Alkalinity

The amount of the alkali agent added to the developer and replenisher is controlled in such a manner that the pH value thereof is not less than 12.0. The pH value of the liquid is preferably set at a level ranging from 12.0 to 13.8 and more preferably 12.5 to 13.6. This is because if the pH value is not less than 12.0, the resulting developer can uniformly dissolve the alkali-soluble resin used in the lithographic printing plate precursor, while if it is not more than 13.8, the pH value of the resulting developer can stably be maintained at a desired level by the addition of a substance having a buffering action. More specifically, the alkalinity of the developer is, for instance, in the range of from 12.0 to 13.7 and preferably 12.5 to 13.5 as expressed in terms of the pH value. On the other hand, it is sufficient that the alkalinity of the replenisher is higher than that of the developer and the alkalinity of the replenisher is so controlled that the pH value thereof is higher than that of the developer by 0.01 to 0.5. These alkalinities can be set at desired levels by appropriately adjusting the amounts of the foregoing alkaline agent and the substance having a buffering action to be added to these liquids.

(2-6-2) Surface Tension

The surface tension of the developer and replenisher is preferably controlled to a level of not more than 650 $\mu$ N/cm (65 dyne/cm) and more preferably not higher than 600 $\mu$ N/cm (60 dyne/cm) in order to make uniform the wettability of the developer and replenisher for the lithographic printing plate precursor and to make the developing ability thereof uniform. The surface tension of these liquids can be determined by, for instance, the oscillating jet technique and there have been known, for instance, an automated dynamic tension meter JET MODEL as such a measuring device.

(3) Materials for Lithographic Printing Plate Precursor

The lithographic printing plate precursor to which the method of the invention is applied comprises a substrate and an image-forming layer provided on the substrate and a primer coating layer as an optional component arranged between the substrate and the image-forming layer. The lithographic printing plate precursor used in the invention is preferably one which comprises a hydrophilic substrate provided thereon with an image-forming layer containing an alkali-soluble resin and more preferably a heat-sensitive positive-working one which comprises a substrate provided

thereon with an image-forming layer containing an infrared-absorbing dye and an alkali-soluble resin. This heat-sensitive positive-working lithographic printing plate precursor will hereunder be described in detail, but the present invention is not restricted to such a specific example at all.

(3-1) Substrate

In the present invention, a hydrophilic substrate is used. Such a hydrophilic substrate may be any dimensionally stable plate-like material having desired strength and durability and specific examples thereof include paper, paper laminated with a plastic film (such as polyethylene, polypropylene or polystyrene film), a metal plate (such as aluminum, zinc or copper plate), a plastic film (such as cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate and polyvinyl acetal films), and paper and plastic films which are laminated with the foregoing metal or on which the foregoing metal is deposited.

Preferably used herein as the substrate is a polyethylene film or an aluminum plate. In particular, the aluminum plate is most preferably used herein because of its excellent dimensional stability and relatively low price. Examples of aluminum plates suitably used herein are a pure aluminum plate; aluminum alloy plates comprising aluminum as a principal component and a trace amount of foreign elements; and plastic films provided thereon with a laminated or deposited aluminum layer. Examples of the foreign elements included in the aluminum alloys are silicon, iron, manganese, copper, magnesium, chromium, zinc bismuth, nickel and titanium. The content of such foreign elements in the aluminum alloy is at most 10% by mass.

The pure aluminum plate is a particularly preferred aluminum substrate usable herein, but it is difficult to produce completely pure aluminum in the light of the refining technique and therefore, the aluminum substrate used herein may contain a trace amount of foreign elements. As has been discussed above, the composition of the aluminum plate is not restricted to specific one and therefore, aluminum plates produced from conventionally known and currently used materials can appropriately be used in the present invention. The thickness of the aluminum plate used in the invention ranges from about 0.1 to 0.6 mm, preferably 0.15 to 0.4 mm and particularly preferably 0.2 to 0.3 mm.

The aluminum plate is, if desired, subjected to degreasing using, for instance, a surfactant, an organic solvent or an aqueous alkaline solution for the removal of the rolling oil from the surface of the plate prior to the surface-roughening treatment. The aluminum plate may be surface-roughened according to a variety of methods and examples thereof include a mechanical surface-roughening method, an electrochemical surface-roughening method in which the surface of an aluminum plate is roughened through dissolution and a chemical method for selectively dissolving the surface of an aluminum plate. The mechanical surface-roughening can be conducted by any known method such as ball graining, brush graining, blast graining and buff graining. The electrochemical surface-roughening method may be, for instance, carried out in an electrolyte solution such as a hydrochloric acid solution or a nitric acid solution while applying a direct or alternating current. It is also possible to use these two methods in combination as disclosed in J. P. KOKAI Sho 54-63902.

The aluminum plate thus surface-roughened is, if desired, subjected to alkali etching and neutralization and then the aluminum plate is, if desired, subjected to an anodization to improve the water retention properties and wear resistance thereof Various kinds of electrolytes which permit the formation of a porous anodized film may be used in the anodization of the aluminum plate and examples thereof commonly used are sulfuric acid, phosphoric acid, oxalic acid, chromic acid and mixtures thereof. The concentration of the electrolyte may appropriately be determined depending on the kind of each electrolyte selected

The conditions for the anodization cannot unconditionally be determined since they may variously vary depending on the electrolyte used, but satisfactory results can in general be obtained when the anodization is carried out under the following conditions: the concentration of the electrolyte solution ranging from 1 to 80% by mass; the temperature of the electrolyte solution ranging from 5 to 70°C; a current density ranging from 5 to 60 A/$dm^2$; a voltage ranging from 1 to 100 V; an electrolyzation time ranging from 10 seconds to 5 minutes. The amount of the anodized film to be deposited is suitably not less than 1.0 g/$m^2$ to ensure a sufficient printing durability, to prevent the formation of any defect on the non-image area of the resulting lithographic printing plate and to thus prevent the occurrence of so-called "contamination due to defects" during printing operations, in which ink is adhered to such defects. After the completion of the anodization, the surface of the aluminum plate is, if necessary, hydrophilized. The aluminum plate may be hydrophilized by, for instance, a method comprising treating the plate with an alkali metal silicate (such as an aqueous sodium silicate solution) as disclosed in U.S. Patent Nos. 2,714,066; 3,181,461; 3,280,734; and 3,902,734. In this method, the substrate is immersed in an aqueous sodium silicate solution or electrolyzed therein. The hydrophilization treatment of the aluminum plate may likewise be conducted by, for instance, treating the plate with potassium fluorozirconate as disclosed in J.P. KOKOKU Sho 36-22063 or polyvinyl-phosphonic acid as disclosed in U.S. Patent Nos. 3,276,868; 4,153,461; and 4,689,272.

(3-2) Image-Forming Layer

The lithographic printing plate precursor used in the present invention is one comprising the foregoing substrate provided thereon with an image-forming layer containing a light-sensitive resin composition. The materials for preparing lithographic printing plate precursors can be classified into various groups: conventional positive-working type one, conventional negative- working type one, light-sensitive polymer type one, heat-sensitive positive-working type one and heat-sensitive negative-working type one. The conventional type ones means the lithographic printing plate precursors of conventional type which are imagewise-exposed to light through a transparent positive or a transparent negative. The light-sensitive polymer type one means a lithographic printing plate precursor having an image-forming layer which comprises, as essential components, an addition-polymerizable ethylenically unsaturated bond-containing compound, a photopolymerization initiator and a polymeric binder. The heat-sensitive type one means a lithographic printing plate precursor which comprises an alkali-soluble polymeric compound and a light-heat conversion substance and in which the light rays or the like absorbed by the light-heat conversion substance is converted into heat and the resin composition is, for instance, cured by the heat thus generated. The heat-sensitive positive-working lithographic printing plate precursor is preferably one provided with an image-forming layer which comprises an infrared light-absorbing dye as such a light-heat conversion substance and in which the structure of the polymeric compound undergoes a change through the irradiation of infrared light and the alkali-soluble resin is thus made soluble. The present invention will hereunder described an image-forming layer comprising an alkali-soluble resin and an infrared light-absorbing dye and used in a heat-sensitive positive-working lithographic printing plate precursor as the most preferred embodiment, but the present invention is not restricted to such a specific image-forming layer at all.

In this respect, the image-forming layer used in the invention may comprise a single layer or a laminated structure (multi-layer structure). The multi-layer type one may comprise an upper heat-sensitive layer which is arranged on the side near the surface (light-exposed face) and contains an alkali-soluble resin and an infrared light-absorbing dye and a lower layer which is arranged on the side of the substrate and contains an alkali-soluble resin. An example thereof is a heat-sensitive positive-working lithographic printing plate precursor comprising a substrate provided thereon with, in order, a lower layer which contains a water-insoluble and alkali-soluble resin and an upper heat-sensitive layer which contains a water-insoluble and alkali-soluble resin and an infrared light-absorbing dye and whose solubility in an aqueous alkali solution is increased by the action of heat. Examples of multi-layer type image-forming layers are those disclosed in J.R KOKAI Hei 11-218914.

(3-2-1) Alkali-Soluble Resins

The alkali-soluble resin used in the present invention is a water-insoluble and alkaline solution-soluble resin (hereinafter also referred to as "alkali-soluble polymer"), and includes homopolymers having an acidic group in the main chain and/or side chain thereof, and copolymers or mixtures thereof Therefore, the image-forming layer of the invention is one having such a characteristic property that it can be dissolved in an alkaline developer when coming in contact therewith.

Any conventionally known alkali-soluble polymers can be used herein without any restriction, but preferably used herein include those having, in the molecule, any one of the following functional groups: (A) phenolic hydroxyl group, (B) sulfonamide group, and (C) active imide group. Examples thereof include those listed below, but the alkali-soluble polymers usable in the present invention are not limited to these specific examples.

(A) Examples of the alkali-soluble polymers having a phenolic hydroxyl group are as follows: novolak resins such as phenol-formaldehyde resin, m-cresol-formaldehyde resin, p-cresol- formaldehyde resin, mixed m-/p-cresol-formaldehyde resin, and mixed phenol/cresol (phenol and cresol may be in m-, p- and/or mixed m-/p-forms)-formaldehyde resin; and pyrogallol-acetone resins. In addition to the above alkali-soluble polymers having a phenolic hydroxyl group, polymers having a phenolic hydroxyl group in the side chain thereof are also preferably used. Such polymers having a phenolic hydroxyl group in the side chain thereof include, for instance, those obtained by homopolymerization of a polymerizable monomer consisting of a low-molecular weight compound which comprises at least one phenolic hydroxyl group and at least one polymerizable unsaturated bond, or those prepared by copolymerization of the foregoing monomer with other polymerizable monomers.

Examples of the polymerizable monomer having a phenolic hydroxyl group used to obtain the polymers having a phenolic hydroxyl group in the side chain thereof include phenolic hydroxyl group-containing acrylamide, methacrylamide, acrylic esters, methacrylic esters and hydroxy-styrene. Specific examples thereof include N-(2-hydroxyphenyl)acrylamide, N-(3-hydroxyphenyl)acrylamide, N-(4-hydroxyphenyl)acrylamide, N-(2-hydroxyphenyl) methacrylamide, N-(3-hydroxyphenyl)methacrylamide, N-(4-hydroxyphenyl)methacrylamide, o-hydroxyphenyl acrylate, m-hydroxyphenyl acrylate, p-hydroxyphenyl acrylate, o-hydroxyphenyl methacrylate, m-hydroxyphenyl methacrylate, p-hydroxyphenyl methacrylate, o-hydroxy-styrene, m-hydroxy-styrene, p-hydroxy-styrene, 2-(2-hydroxyphenyl)ethyl acrylate, 2-(3-hydroxyphenyl) ethyl acrylate, 2-(4-hydroxyphenyl)ethyl acrylate, 2-(2-hydroxyphenyl)ethyl methacrylate, 2-(3-hydroxyphenyl)ethyl methacrylate and 2-(4-hydroxyphenyl)ethyl methacrylate.

These phenolic hydroxyl group-containing resins may be used alone or in any combination. Moreover, polycondensates of phenols having, as a substituent, an alkyl group with 3 to 8 carbon atoms and formaldehyde, such as t-butyl-phenolformaldehyde resin and octyl-phenol- formaldehyde resin may be used together, as disclosed in U.S. Patent No. 4,123,279.

(B) Examples of the alkali-soluble polymers having a sulfonamide group include polymers obtained by homopolymerization of sulfonamide group-containing polymerizable monomers or copolymerization of the above polymerizable monomers with other polymerizable monomers. The sulfonamide group-containing polymerizable monomer may be a low-molecular weight compound having, in the molecule, (i) at least one sulfonamide group ($-NH-SO_2-$) having at least one hydrogen atom bonded to the nitrogen atom, and (ii) at least one polymerizable unsaturated bond. In particular, low-molecular weight compounds having an acryloyl, allyl or vinyloxy group, and a substituted- or monosubstituted-aminosulfonyl or substituted-sulfonylimino group are preferably used herein.

(C) The active imide group-containing alkali-soluble polymers are preferably those having an active imide group in the molecule. Examples of such polymers include those obtained by homopolymerization of a polymerizable monomer consisting of a low-molecular weight compound having, in the molecule, one or more active imide groups and one or more polymerizable unsaturated bonds, or copolymerization of the foregoing monomers with other polymerizable monomers. Specific examples thereof preferably used herein are N-(p-toluene-sulfonyl) methacrylamide and N-(p-toluene-sulfonyl)acrylamide.

Moreover, preferably employed are polymers obtained by polymerizing two or more polymerizable monomers selected from the group consisting of (a) the phenol group- containing polymerizable monomers, (b) the sulfonamide group-containing polymerizable monomers, and (c) the active imide group-containing polymerizable monomers listed above, and polymers obtained by subjecting the above-mentioned two or more polymerizable monomers to copolymerization with other polymerizable monomers. In the case where the phenolic hydroxyl group-containing polymerizable monomer (a) is subjected to copolymerization with the sulfonamide group- containing polymerizable monomer (b) and/or the active imide group-containing polymerizable monomer (c), the mixing ratio by weight (a : b and/or c) is preferably in the range of (50:50) to (5:95) and more preferably (40:60) to (10:90).

In the case where the alkali-soluble polymer is a copolymer consisting of one monomer unit selected from the above-mentioned monomers having either of the foregoing acidic groups (A) to (C) and another monomer unit of other polymerizable monomers, it is preferable that the monomer unit having either of the foregoing acidic groups (A) to (C) be contained in an amount of 10 mol% or more from the aspect of obtaining sufficient alkali-solubility to expand development latitude, more preferably 20 mol% or more, in the foregoing copolymer. The foregoing copolymers may be prepared by any conventionally known method such as graft copolymerization, block copolymerization, or random copolymerization.

The monomer components that can be used for copolymerization with the above-mentioned polymerizable phenolic hydroxyl group-containing monomers (a), sulfonamide group-containing monomers (b), and active imide group-containing monomers (c) are classified into the following groups (m1) to (m12). However, the monomer components are not limited to the following examples.

(m1): Acrylic esters and methacrylic esters having an aliphatic hydroxyl group, such as 2-hydroxyethyl acrylate and 2-hydroxyethyl methacrylate.

(m2): Alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, and glycidyl acrylate.

(m3): Alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, and glycidyl methacrylate.

(m4): Acrylamides and methacrylamides such as acrylamide, methacrylamide, N-methylol-acrylamide, N-ethylacrylamide, N-hexyl-methacrylamide, N-cyclohexylacrylamide, N-hydroxyethyl-accylamide, N-phenyl-acrylamide, N-nitrophenylacrylamide, and N-ethyl-N- phenyl-acrylamide.

(m5): Vinyl ethers such as ethyl vinyl ether, 2-chloroethyl vinyl ether, hydroxyethyl vinyl ether, propyl vinyl ether, butyl vinyl ether, octyl vinyl ether, and phenyl vinyl ether.

(m6): Vinyl esters such as vinyl acetate, vinyl chloro-acetate, vinyl butyrate, and vinyl benzoate.

(m7): Styrenes such as styrene, $\alpha$ -methylstyrene, methylstyrene, and chloromethylstyrene.

(m8): Vinyl ketones such as methyl vinyl ketone, ethyl vinyl ketone, propyl vinyl ketone, and phenyl vinyl ketone.

(m9): Olefins such as ethylene, propylene, isobutylene, butadiene, and isoprene.

(m10): N-vinylpyrrolidone, acrylonitrile, and methacrylonitrile.

(m11): Unsaturated imides such as maleimide, N-acryloyl-acrylamide, N-acetyl- methacrylamide, N-propionyl-methacrylamide, and N-(p-chlorobenzoyl)methacrylamide.
(m12): Unsaturated carboxylic acids such as acrylic acid, methacrylic acid, maleic anhydride, and itaconic acid.

(D) An alkali-soluble polymer compound having carboxyl group [hereinafter referred to as component (D)] may also be used together as the alkali-soluble polymer. Although this compound may be any of the alkali-soluble polymer compounds having carboxyl group, polymer compounds (D-1) and (D-2) as defined below are preferred.

(D-1) Alkali-soluble polymer compounds having a polymerizable monomer unit represented by the following general formula (III) [hereinafter referred to as "polymer compound (D-1)]":

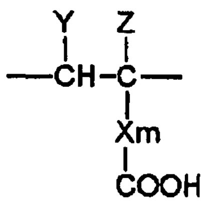

(III)

wherein Xm represents a single bond or a divalent connecting group, Y represents hydrogen or carboxyl group, and Z represents hydrogen, an alkyl group or carboxyl group.

The monomers constituting the polymerizable monomer units represented by general formula (III) include polymerizable monomers having at least one carboxyl group and at least one polymerizable unsaturated group in the molecule. Examples of the polymerizable monomers include α , β -unsaturated carboxylic acids such as acrylic acid, methacrylic acid, maleic acid, maleic anhydride, itaconic acid and itaconic anhydride.

The monomers to be copolymerized with the polymerizable monomer having carboxyl group are, for example, the following monomers (d1) to (d11):

(d1) Acrylic esters and methacrylic esters having an aliphatic hydroxyl group such as 2-hydroxyethyl acrylate and 2-hydroxyethyl methacrylate,
(d2) Alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, glycidyl acrylate and N-dimethylaminoethyl acrylate,
(d3) Alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, glycidyl methacrylate and N-dimethylaminoethyl methacrylate,
(d4) Acrylamides and methacrylamides such as acrylamide, methacrylamides, N-methylolacrylamide, N-ethylacrylamide, N-hexylmethacrylamide, N-cyclohexylacrylamide, N-hydroxyethylacryl-amide, N-phenylacrylamide, N-nitrophenylacrylamide and N-ethyl-N-phenylacrylamide,
(d5) Vinyl ethers such as ethyl vinyl ether, 2-chloroethyl vinyl ether, hydroxyethyl vinyl ether, propyl vinyl ether, butyl vinyl ether, octyl vinyl ether and phenyl vinyl ether,
(d6) Vinyl esters such as vinyl acetate, vinyl chloroacetate, vinyl butyrate and vinyl benzoate,
(d7) Styrenes such as styrene, α -methylstyrene, methylstyrene and chloromethylstyrene,
(d8) Vinylketones such as methyl vinyl ketone, ethyl vinyl ketone, propyl vinyl ketone and phenyl vinyl ketone,
(d9) Olefins such as ethylene, propylene, isobutylene, butadiene and isoprene,
(d10) N-vinylpyrrolidone, N-vinylcarbazole, 4-vinylpyridine, acrylonitrile and methacrylonitrile,
(d11) Unsaturated imides such as maleimide, N-acryloylacrylamide, N-acetylmethacrylamide, N-propionylmethacrylamide and N-(p-chlorobenzoyl)methacrylamide.

Monomers of the following general formula (IV) are also preferably used:

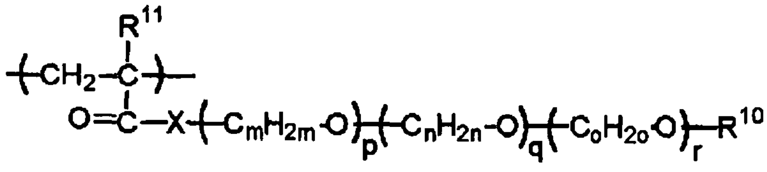 (IV)

wherein X represents O, S or N-$R^{12}$, $R^{10}$ to $R^{12}$ independently represent hydrogen atom or an alkyl group, m, n and o represent an integer of 2 to 5, $C_mH_{2m}$, $C_nH_{2n}$ and $C_oH_{2o}$ may have either linear or branched structure, and p, q and r independently represent an integer of 0 to 3,000, and $p+q+r \geqq 2$.

The alkyl groups in $R^{10}$ to $R^{12}$ are preferably those having 1 to 12 carbon atoms such as methyl group, ethyl group, n-propyl group and isopropyl group. P, q and r are preferably integers of 0 to 500, more preferably integers of 0 to 100.

Examples of the monomers corresponding to the recurring units of general formula (IV) are given below, which by no means limit the monomers.

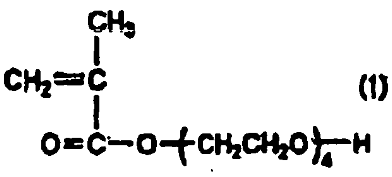 (1) 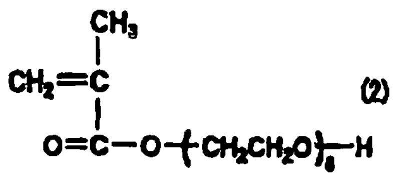 (2)

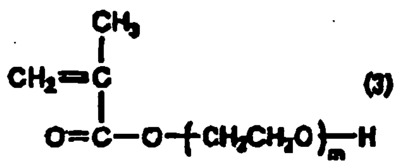 (3) 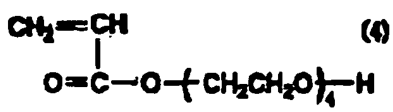 (4)

(average molecular weight of alkylene oxides: 1000)

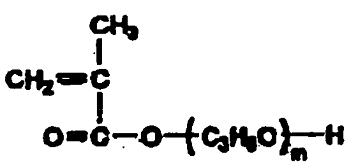 (5) 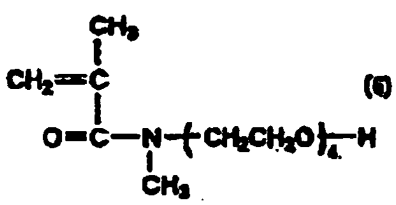 (6)

(average molecular weight of alkylene oxides: 1000)

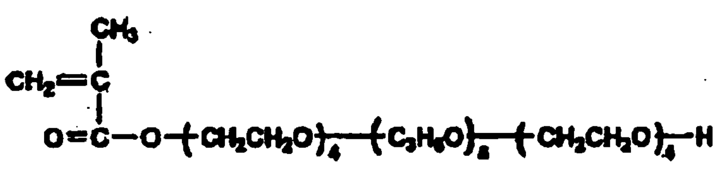 (7)

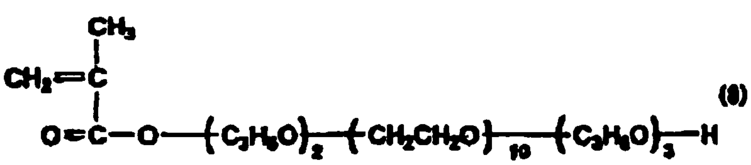 (8)

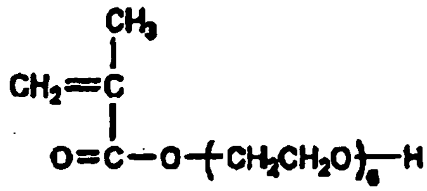

(9)

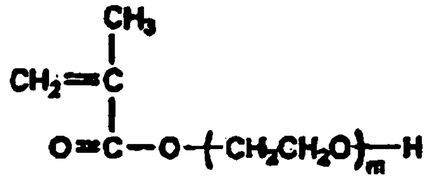

(10)

(average molecular weight of alkylene oxides: 500)

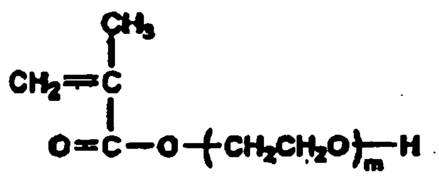

(11)

(average molecular weight of alkylene oxides: 2000)

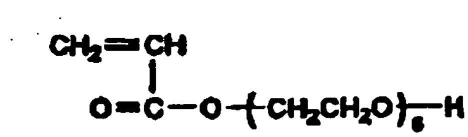

(12)

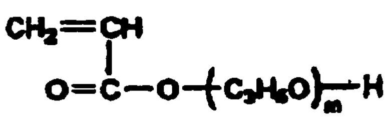

(13)

(average molecular weight of alkylene oxides: 1500)

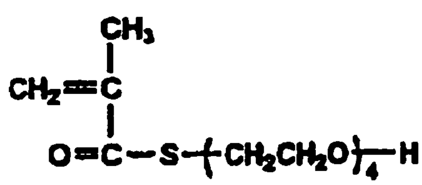

(14)

The recurring units represented by the above general formula (IV) can be produced by reacting a commercially available hydroxypoly(oxy-alkylene) material such as that sold under a trade name of Pluronic (Asahi Denka Kogyo K.K), Adeka polyether (Asahi Denka Kogyo K.K.), Carbowax (Glyco Products), Toriton (Rohm and Haas) or P.E.G. (Daiichi-Kogyo Seiyaku Co., Ltd.) with acrylic acid, methacrylic acid, acryl chloride, methacryl chloride, acrylic anhydride or the like. Poly(oxyalkylene) diacrylates produced by a known method are also usable.

The commercially available monomers are, for example, polyalkylene glycol mono(meth)acrylates having terminal hydroxyl group (products of Nippon Oil and Fats Co., Ltd.) such as Blemmer PE-90, Blemmer PE-200, Blemmer

PE-350, Blemmer AE-90, Blemmer AE-200, Blemmer AE-400, Blemmer PP-1000, Blemmer PP-500, Blemmer PP-800, Blemmer AP-150, Blemmer AP-400, Blemmer AP-550, Blemmer AP-800, Blemmer 50PEP-300, Blemmer 70PEP-350B, Blemmer AEP series, Blemmer 55PET-400, Blemmer30PET-800, Blemmer 55PET-800, Blemmer AET series, Blemmer 30PPT-800, Blemmer 50PPT-800, Blemmer70PPT-800, BlemmerAPT series, Blemmer10PPB-500B andBlemmer 10 APB-500B. The polyalkylene glycol mono(meth)acrylates having a terminal alkyl group (products of Nippon Oil and Fats Co., Ltd.) includeBlemmer PME-100, BlemmerPME-200, Blemmer PME 400, Blemmer PME-1000, Blemmer PME-4000, Blemmer AME-400, Blemmer 50POEP-800B, Blemmer 50AOEP-800B, Blemmer PLE-200, Blemmer ALE-200, Blemmer ALE-800, Blemmer PSE-400, Blemmer PSE-1300, Blemmer ASEP series, Blemmer PKEP series, Blemmer AKEP series, Blemmer ANE-300, Blemmer ANE-1300, Blemmer PNEP series, Blemmer PNPE series, Blemmer 43ANEP-500 and Blemmer 70ANEP-550. The commercially available monomers also include Light Ester MC, Light Ester 130MA, Light Ester 041MA, Light Acrylate BO-A, Light Acrylate EC-A, Light Acrylate MTG-A, Light Acrylate 130A, Light Acrylate DPM-A, Light Acrylate P-200A, Light Acrylate NP-4EA and Light Acrylate NP-8EA of Kyoei Kagaku Co., Ltd.

The minimum constituting unit having a polymerizable monomer component having at least one carboxyl group and at least one polymerizable unsaturated group in the molecule of the polymer compound (D-1) is not particularly limited to only one kind of the unit. A copolymer obtained by copolymerizing two or more kinds of the minimum constituting units having the same acidic group or two or more kinds of the minimum constituting units having different acidic groups is also usable.

The copolymerization methods are, for example, known graft copolymerization method, block copolymerization method and random copolymerization method

(D-2) Alkali-soluble polymer compounds having carboxyl group and a reaction product of a diol compound and a diisocyanate compound as the basic skeleton [hereinafter referred to as "polymer compounds (D-2)]:

(D-2-1) The diol compounds include those of the following general formula (V), (VI) or (VII) having carboxyl group:

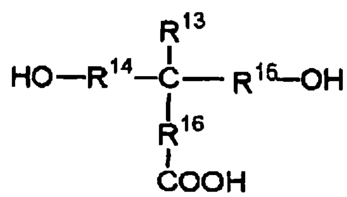

(V)

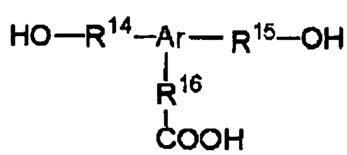

(VI)

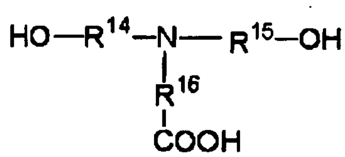

(VII)

$R^{13}$ represents hydrogen atom or an alkyl, alkenyl, aralkyl, aryl, alkoxyl or aryloxyl group which may have a substituent (preferably, for example, an alkyl, aryl, alkoxyl, ester, urethane, amido, ureido or halogeno group). $R^{13}$ is preferably hydrogen atom, an alkyl group having 1 to 8 carbon atoms, an alkenyl group having 2 to 8 carbon atoms or an aryl group having 6 to 15 carbon atoms. $R^{14}$, $R^{15}$ and $R^{16}$ may be the same or different from one another. $R^{14}$, $R^{15}$ and $R^{16}$ each represent a divalent aliphatic or aromatic hydrocarbon group having a single bond or a substituent (preferably, for example, an alkyl, alkenyl, aralkyl, aryl, alkoxyl or halogeno group). Preferably, $R^{14}$, $R^{15}$ and $R^{16}$ each represent an alkylene group having 1 to 20 carbon atoms or an

arylene group having 6 to 15 carbon atoms. More preferably, they each represent an alkylene group having 1 to 8 carbon atoms. If necessary, $R^{14}$, $R^{15}$ and $R^{16}$ may have another functional group, which does not react with the isocyanato group, such as an ester group, urethane group, amido group, ureido group or carbon-to-carbon unsaturated bond. Two or three of $R^{13}$, $R^{14}$, $R^{15}$ and $R^{16}$ may constitute a ring. Ar represents a trivalent aromatic hydrocarbon group which may have a substituent. Preferably Ar represents an aromatic group having 6 to 15 carbon atoms.

Examples of the diol compounds having carboxyl group and represented by general formula (V), (VI) or (VII) are as follows: 3,5-dihydroxybenzoic acid, 2,2-bis(hydroxymethyl)propionic acid, 2,2-bis(2-hydroxyethyl) propionic acid, 2,2-bis(3-hydroxypropyl)propionic acid, bis(hydroxymethyl)acetic acid, bis(4-hydroxyphenyl) acetic acid, 4,4-bis(4-hydroxyphenyl)pentanoic acid, tartaric acid and N,N-bis(2-hydroxyethyl)-3-carboxypropionamide.

The alkali-soluble polymer compounds (D-2) having carboxyl group are preferably reaction products each comprising a combination of diols of the following general formula (VIII) or (IX):

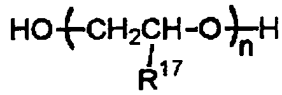

(VIII)

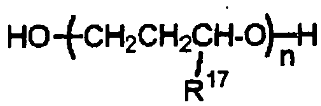

(IX)

wherein $R^{17}$ each represent hydrogen atom or an alkyl group having 1 to 8 carbon atoms, and n represents an integer of at least 2. The alkyl groups having 1 to 8 carbon atoms in $R^{17}$ are, for example, methyl group, ethyl group, i-propyl group, n-butyl group and i-butyl group.

Examples of the diols represented by the above general formula (VIII) or (IX) are as follows, which by no means limit the diols of the present invention. Examples of (VIII):

$HO-(-CH_2CH_2O-)_3-H$
$HO-(-CH_2CH_2O-)_4-H$
$HO-(-CH_2CH_2O-)_5-H$
$HO-(-CH_2CH_2O-)_6-H$
$HO-(-CH_2CH_2O-)_7-H$
$HO-(-CH_2CH_2O-)_8-H$
$HO-(-CH_2CH_2O-)_{10}-H$
$HO-(-CH_2CH_2O-)_{12}-H$
Polyethylene glycol (average molecular weight: 1000)
Polyethylene glycol (average molecular weight: 2000)
Polyethylene glycol (average molecular weight: 4000)
$HO-(-CH_2CH(CH_3O-)_3-H$
$HO-(-CH_2CH(CH_3)O-)_4-H$
$HO-(-CH_2CH(CH_3)O-)_6-H$
Polypropylene glycol (average molecular weight: 1000)
Polypropylene glycol (average molecular weight: 2000)
Polypropylene glycol (average molecular weight: 4000)
Examples of (IX):
$HO-(-CH_2CH_2CH_2O-)_3-H$
$HO-(-CH_2CH_2CH_2O-)_4-H$
$HO-(-CH_2CH_2CH_2O-)_8-H$
$HO-(-CH_2CH_2CH(CH_3)O-)_{12}-H$

(D-2-2) Diisocyanate compounds

The diisocyanate compounds include those of the following general formula (X):

$$OCN\text{-}R^{18}\text{-}NCO \qquad (X)$$

wherein $R^{18}$ represents a divalent aliphatic or aromatic hydrocarbon group which may have a substituent (preferably an alkyl, alkenyl, aralkyl, aryl, alkoxyl or halogeno group). If necessary, $R^{18}$ may have another functional group, which does not react with isocyanato group, such as an ester, urethane, amido or ureido group or carbon-to-carbon unsaturated bond.

The diisocyanate compounds of the general formula (X) are, for example, aromatic diisocyanate compounds such as 2,4-tolylene diisocyanate, 2,4-tolylene diisocyanate dimer, 2,6-tolylene diisocyanate, p-xylylene diisocyanate, m-xylylene diisocyanate, 4,4'-diphenylmethane diisocyanate, 1,5-naphthalene diisocyanate and 3,3'-dimethylbiphenyl-4,4'-diisocyanate; aliphatic diisocyanate compounds such as hexamethylene diisocyanate, trimethylhexamethylene diisocyanate, lysine diisocyanate and dimer acid diisocyanate; aliphatic diisocyanate compounds such as isophorone diisocyanate, 4,4'-methylenebis(cyclohexyl isocyanato), methylcyclohexane-2,4(or 2,6)-diisocyanate and 1,3-(isocyanatomethyl)cyclohexane; and reaction products of a diol and a diisocyanate such as an adduct of 1 mol of 1,3-butylene glycol and 2 mols of tolylene diisocyanate.

The molar ratio of the diisocyanate compound (D-2-2) to the diol compound (D-2-1) used for synthesizing the polymer compound (D-2) is preferably 0.8:1 to 1.2~ 1. When isocyanato group remains at the end of the polymer, the final product free from the isocyanato group can be synthesized by treating it with an alcohol, an amine or the like.

Component (D) may be one of the above-described polymer compounds (D-1) and (D-2) or a combination of two or more of them. The amount of the carboxyl group-containing recurring units in component (D) is at least 2 molar %, preferably in the range of 2 to 70 molar % and more preferably 5 to 60 molar % based on the total of the monomers in component (D). The mass average molecular weight of component (D) is preferably 3,000 to 300,000 and more preferably 6,000 to 100,000.

The alkali-soluble resin content of the image-forming layer is 30 to 99 mass %, preferably 40 to 95 mass % and more preferably 50 to 90 mass % based on the total solid content of the image-forming layer from the viewpoint of the durability and sensitivity

When component (D) is contained in the image-forming layer, the amount of component (D) is in the range of 0.005 to 80 % by mass, preferably 0.01 to 50 % by mass and more preferably 1 to 20 % by mass based on the total solid content of the image-forming layer.

When the alkali-soluble polymer in the present invention is a homopolymer or a copolymer of a polymerizable monomer having the phenolic hydroxyl group, a polymerizable monomer having sulfonamido group or a polymerizable monomer having an active imido group, the polymer preferably has a mass average molecular weight of at least 2,000 and a number average molecular weight of at least 500. More preferably, the polymer has a mass average molecular weight of 5,000 to 300,000, a number average molecular weight of 800 to 250,000 and a degree of dispersion (mass average molecular weight / number average molecular weight) of 1.1 to 10.

When the alkali-soluble polymer is a resin such as phenol formaldehyde resin or cresol aldehyde resin in the present invention, the mass average molecular weight of the resin is preferably 500 to 20,000 and number average molecular weight thereof is 200 to 10,000.

When the image-forming layer has a laminate structure, one or a combination of two or more of the above-described alkali-soluble polymers can be used for forming the upper heat-sensitive layer. Particularly in the upper heat-sensitive layer, a resin having phenolic hydroxyl group is preferred and novolac resin is more preferred because it exhibits a strong hydrogen-bonding power in unexposed regions and hydrogen bonds are partially easily removed in exposed regions.

One or the combination of two or more of the above-described alkali-soluble polymers can be used for forming the under layer. Particularly for forming the under layer, a resin on which development inhibition effect of a development inhibitor in a developer is not exerted is preferably used. Preferred resins other than the novolac resin are, for example, acrylic resins. In the acrylic resins, those having sulfoamido group are particularly preferred. Those resins are usable either alone or in the form of a combination of two or more of them.

The under layer may substantially comprise the alkali-soluble polymer(s).

The alkali-soluble polymer compounds in the upper heat-sensitive layer are used in an amount of 50 to 90 mass % in total. When the amount of the alkali-soluble polymer is 50 mass % or higher, the durability of the upper heat-sensitive layer is not reduced and 90 mass % or lower of the amount thereof is desirable from the viewpoint of the sensitivity and durability. The mixing ratio of two alkali-soluble polymer compounds having different solution velocities in the aqueous alkali solution is not limited. In the alkali-soluble polymer compounds, those having a phenolic hydroxyl group which causes a strong hydrogen-bonding power in unexposed regions and which also causes easy partial removal of hydrogen bonds in exposed regions are used in an amount of 60 to 99.8 mass %. A sufficient image-forming property can be obtained when the amount of the alkali-soluble polymer compound having the phenolic hydroxyl group is at least 60 %.

(3-2-2) Infrared-absorbing dyes

The infrared-absorbing dyes used for forming the image-forming layer in the present invention are not particularly limited so far as they absorb infrared rays to generate heat. Various dyes known to be infrared-absorbing dyes are usable.

As the infrared-absorbing dyes in the present invention, those available on the market and described in literatures [such as "Senryo Binran" (Handbook of Dyes) edited by Yuki Gosei Kagaku Kyokai and published in 1970] are usable. They are, for example, azo dyes, metal complex salts of azo dyes, pyrazolone azo dyes, anthraquinone dyes, phthalocyanine dyes, carbonium dyes, quinoneimine dyes, methine dyes and cyanine dyes. In these dyes, those which absorb infrared rays or near-infrared rays are particularly preferred because they are suitable for use with a laser for the infrared rays or near-infrared rays.

The dyes which absorb infrared rays or near-infrared rays are, for example, cyanine dyes described in J. P. KOKAI Nos. Sho 58-125246, Sho 59-84356, Sho 59-202829 and Sho 60-78787, methine dyes described in J. P. KOKOI Nos. Sho 58-173696, Sho 58-181690 and Sho 58-194595, naphthoquinone dyes described in J. P. KOKAI Nos. Sho 58-112793, Sho 58-224793, Sho 59-48187, Sho 59-73996, Sho 60-52940 and Sho 60-63744, squarylium colorant described in J. P. KOKAI No. Sho 58-112792 and cyanine dyes described in British Patent No. 434,875.

Near-infrared absorbing sensitizers described in U. S. Patent No. 5,156,938 are also preferably used as the dyes. Preferred dyes are, for example, substituted arylbenzo(thio)pyrylium salts described in U. S. Patent No. 3,881,924, trimethine thiapyrylium salts described in J. P. KOKAI No. Sho 57-142645 (U. S. Patent No. 4,327,196), pyrylium compounds described in J. P. KOKAI Nos. Sho 58-181051, 58-220143, 59-41363, 59-84248, 59-84249, 59-146063 and 59-146061, cyanine colorants described in J. P. KOKAI No. Sho 59-216146, pentamethine thiopyrylium salts described in U. S. Patent No. 4,283,475, and pyrylium compounds disclosed in J. P. KOKOKU Nos. Hei 5-13514 and 5-19702. Particularly preferred dyes available on the market are, for example, Epolight III-178, Epolight III-130 and Epolight III-125 (products of Epolin). Other examples of particularly preferred dyes are near-infrared absorbing dyes of formulae (I) and (II) shown in the specification of U. S. Patent No. 4,756,993.

The infrared absorbing dye content of the image-forming layer is preferably 0.01 to 50 mass %, more preferably 0.1 to 30 mass %, and most preferably 0.5 to 10 mass % based on the total solid content of the image-forming layer. When the infrared absorbing dye content is at least 0.01 mass %, a sufficient sensitivity can be obtained and when it is not higher than 50 mass %, the homogeneity of the image-forming layer is not lowered and also the durability of the image-forming layer is not reduced. The infrared-absorbing dyes may be incorporated into a layer together with other components or into another layer.

When the image-forming layer has a laminate structure, the infrared-absorbing dyes can be added not only to the upper heat-sensitive layer but also the under layer. When the infrared-absorbing dye is added to the under layer, this layer can also function as the heat-sensitive layer. When the infrared-absorbing dye is to be added to the under layer, the dye may be the same as or different from the dye added to the upper heat-sensitive layer.

The infrared-absorbing dye may be incorporated into a layer together with other components or into another layer. In the latter case, the dye is desirably incorporated into a layer adjacent to the heat-sensitive layer. Although the dye and the alkali-soluble resin are preferably contained in the same layer, they may be contained in different layers.

The amount of the dye can be 0.01 to 50 mass %, preferably 0.1 to 30 mass % and particularly preferably 1.0 to 30 mass % based on the total solid materials of the lithographic printing plate precursor (excluding the substrate). When the amount of the dye is at least 0.01 mass %, an excellent sensitivity can be obtained and when it is not larger than 50 mass %, the homogeneity of the upper heat-sensitive layer is not damaged and the durability of this layer is not reduced.

The infrared absorbing dye can be added to the under layer in an amount of 0 to 20 mass %, preferably 0 to 10 mass % and particularly preferably 0 to 5 mass %, based on the solid content of the under layer. Although the solubility of the lower layer is lowered by the addition of the infrared absorbing dye to the layer, the improvement in the solubility of the lower layer by heat in the step of the exposure can be expected by the addition of the infrared absorbing dye. However, in 0.2 to 0.3 μm region near the substrate, the solubility is not improved by heat in the exposing step and the lowering of the solubility in the under layer by the addition of the infrared absorbing dye causes the reduction in the sensitivity. Therefore, even within the above-described range of the amount, preferred amount is such that the solution velocity in the lower layer is above 30 nm.

(3-2-3) Other additives

In the formation of the image-forming layer, various additives can also be added, if necessary, so far as the

effect of the present invention is not damaged When the image-forming layer has a laminate structure, the additives may be contained in only the under layer or only the upper heat-sensitive layer, or they may be contained in both layers. The description will be made below on examples of the additives.

(A) Solubility inhibitors

Various solubility inhibitors can be incorporated into the image-forming layer of the heat-sensitive lithographic printing plate precursor for the purpose of improving the inhibition thereof. The solubility inhibitors are not particularly limited. Examples of them include (A-1) quaternary ammonium salts, (A-2) polyethylene compounds, (A-3) abrasion resistance improvers and (A-4) others.

(A-1) Quaternary ammonium salts

The quaternary ammonium salts are not particularly limited and they include tetraalkylammonium salts, trialkylarylammonium salts, dialkyldiarylammonium salts, alkyltriarylammonium salts, tetraarylammonium salts, cyclic ammonium salts and bicyclic ammonium salts. Concretely, the quaternary ammonium salts include tetrabutylammonium bromide, tetrapentylammonium bromide, tetrahexylammonium bromide, tetraoctylammonium bromide, tetralaurylammonium bromide, tetraphenylammonium bromide, tetranaphthylammonium bromide, tetrabutylammonium chloride, tetrabutylammonium iodide, tetrastearylammonium bromide, lauryltrimethylammonium bromide, stearyltrimethylammonium bromide, behenyltrimethylammonium bromide, lauryltriethylammonium bromide, phenyltrimethylammonium bromide, 3-trifluoromethylphenyltrimethylammonium bromide, benzyltrimethylammonium bromide, dibenzyldimethylammonium bromide, distearyldimethylammonium bromide, tristearylmethylammonium bromide, benzyltriethylammonium bromide, hydroxyphenyltrimethylammonium bromide and N-methylpyridinium bromide. Particularly preferred quaternary ammonium salts are those described in Japanese Patent Application Nos. 126297/2001, 370059/2001 and 398047/2001.

The amount of the quaternary ammonium salt is preferably 0.1 to 50 mass %, more preferably 1 to 30 mass %, based on the total solid content of the image-forming layer. When the amount of the quaternary ammonium salt is at least 0.1 mass %, a sufficient solubility inhibiting effect can be obtained and, when it is not larger than 50 mass %, no bad influence is exerted on the film-forming property of a binder.

(A-2) Polyethylene glycol compounds

Polyethylene glycol compounds are not particularly limited, and they include those having the following structure:

$$R^1\text{-}\{\text{-}O\text{-}(R_3\text{-}O\text{-})_m\text{-}R^2\}_n$$

wherein $R^1$ represents a polyhydric alcohol residue or a polyhydric phenol residue, $R^2$ represents hydrogen atom or a C1-25 alkyl group, alkenyl group, alkynyl group, alkyloyl group, aryl group or aryloxyl group which may have a C1-25 substituent, $R^3$ represents an alkylene residue which may have a substituent, m is an integer of at least 10 on average, and n is an integer of 1 to 4 on average.

The polyethylene glycol compounds having the structure given above are, for example, polyethylene glycols, polypropylene glycols, polyethylene glycol alkyl ethers, polypropylene glycol alkyl ethers, polyethylene glycol aryl ethers, polypropylene glycol aryl ethers, polyethylene glycol alkylaryl ethers, polypropylene glycol alkylaryl ethers, polyethylene glycol glycerol esters, polypropylene glycol glycerol esters, polyethylene sorbitol esters, poly-propylene glycol sorbitol esters, polyethylene glycol fatty acid esters, polypropylene glycol fatty acid esters, ethylenediamine polyethylene glycolates, ethylenediamine polypropylene glycolates, diethylenetriamine polyethylene glycolates and diethylenetriamine polypropylene glycolates.

Examples of the polyethylene glycol compounds are Polyethylene glycol 1000, Polyethylene glycol 2000, Polyethylene glycol 4000, Polyethylene glycol 10000, Polyethylene glycol 20000, Polyethylene glycol 5000, Polyethylene glycol 100000, Polyethylene glycol 200000, Polyethylene glycol 500000, Polypropylene glycol 1500, Polypropylene glycol 3000, Polypropylene glycol 4000, polyethylene glycol methyl ether, polyethylene glycol ethyl ether, polyethylene glycol phenyl ether, polyethylene glycol dimethyl ether, polyethylene glycol diethyl ether, polyethylene glycol diphenyl ether, polyethylene glycol lauryl ether, polyethylene glycol dilauryl ether, polyethylene glycol nonyl ether, polyethylene glycol cetyl ether, polyethylene glycol stearyl ether, polyethylene glycol distearyl ether, polyethylene glycol behenyl ether, polyethylene glycol dibehenyl ether, polypropylene glycol methyl ether, polypropylene glycol ethyl ether, polypropylene glycol phenyl ether, polypropylene glycol dimethyl ether, polypropylene glycol diethyl ether, polypropylene glycol diphenyl ether, polypropylene glycol lauryl ether, polypropylene glycol dilauryl ether, polypropylene glycol nonyl ether, polyethylene glycol acetylate, polyethylene glycol diacetylate, polyethylene glycol benzoate, polyethylene glycol lauate, polyethylene glycol dilaurate, polyethylene glycol nonylate, polyethylene glycol cetylate, polyethylene glycol stearate, polyethylene glycol distearate, polyethylene glycol behenate, polyethylene glycol dibehenate, polypropylene glycol acetate, polypropylene glycol diacetate, polypropylene glycol benzoate, polypropylene glycol dibenzoate, polypropylene glycol laurate, polypropylene glycol dilaurate, polypropylene glycol nonylate, polyethylene glycol glycerol ether, polypropylene glycol glycerol ether, polyethylene glycol sorbitol ether, polypropylene glycol sorbitol ether, ethylenediamine polyethylene glycolate, ethylenediamine polypropylene glycolate, diethylenetriamine polyethylene glycolate, diethylenetriamine polypropylene glycolate and pentamethylenehexamine polyethylene glycolate.

The amount of the solid polyethylene glycol compound is preferably 0.1 to 50 mass %, more preferably 1 to 30 mass %, based on the total solid content of the image-forming layer. When the amount of this compound is at least 0.1 mass %, a sufficient solubility-inhibiting effect can be obtained. When the amount of this polyethylene glycol compound is not larger than 50 mass %, this compound having no mutual effect with the binder does not accelerate the penetration of the developer and also it does not exert a bad influence on the image-forming property.

In the step of improving the solubility inhibition, it is effective to add a lactone compound for inhibiting the lowering of the sensitivity. It is considered that when the developer penetrates into the exposed regions, the developer reacts with the lactone compound to newly form a carboxylic acid compound which contributes to the solution of the exposed regions to improve the sensitivity.

The lactone compounds are not particularly limited and they include, for example, compounds of the following general formulae (L-I) and (L-II):

General formula (L-I)

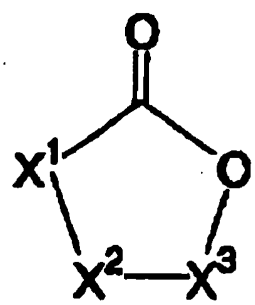

General formula (L-II)

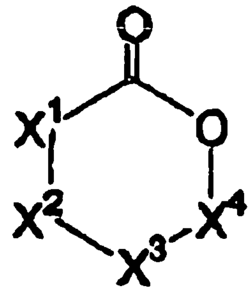

In the general formulae (L-I) and (L-II), $X^1$, $X^2$, $X^3$ and $X^4$ may be the same or different from one another and they each represent an atom or atomic group constituting the ring. They may independently have a substituent. At least one of $X^1$, $X^2$ and $X^3$ in the general formula (L-I) and at least one of $X^1$, $X^2$, $X^3$ and $X^4$ in the general formula (L-II) have a substituent substituted with an electron-attractive substituent or an electron-attractive group.

The atoms or atomic groups constituting the ring and represented by $X^1$, $X^2$, $X^3$ and $X^4$ are each a non-metallic atom or atomic group having two single bonds for constituting the ring.

Preferred non-metallic atoms or non-metallic atomic groups are selected from the group consisting of methylene group, sulfinyl group, carbonyl group, thiocarbonyl group, sulfonyl group, sulfur atom, oxygen atom and selenium atom. More preferably they are atomic groups selected from the group consisting of methylene group, carbonyl group and sulfonyl group.

At least one of $X^1$, $X^2$ and $X^3$ in the general formula (L-I) and at least one of $X^1$, $X^2$, $X^3$ and $X^4$ in the general formula (L-II) have an electron-attractive group. The term "electron-attractive substituents" in the present invention indicates groups having a positive Hammett's substituent constant σ p. As for Hammett's substituent constant σ p, refer to Journal of Medicinal Chemistry, 1973, Vol. 16, No. 11, 1207-1216 or the like. The electron-attractive substituents having a positive Hammett's substituent constant σ p are, for example, halogen atoms [fluorine atom (σ p: 0.06), chlorine atom (σ p: 0.23), bromine atom (σ p: 0.23) and iodine atom (σ p: 0.18)], trihaloalkyl groups [tribromomethyl (σ p: 0.29), trichloromethyl (σ p: 0.33) and trifluoromethyl (σ p: 0.54)], cyano group (σ p: 0.66), nitro group (σ p: 0.78), aliphatic aryl or heterocyclic sulfonyl groups [such as methanesulfonyl (σ p: 0.72)], aliphatic aryl or heterocyclic acyl groups [such as acetyl (σ p: 0.50) and benzoyl (σ p: 0.43)], alkynyl groups [such as $C \equiv CH$ (σ p: 0.23)], aliphatic aryl or heterocyclic oxycarbonyl groups [such as methoxycarbonyl (σ p: 0.45) or phenoxycarbonyl (σ p: 0.44)], carbamoyl group (σ p: 0.36), sulfamoyl group (σ p: 0.57), sulfoxido group, heterocyclic groups, oxo group and phosphoryl group.

Preferred electron-attractive groups are, for example, amido group, azo group, nitro group, fluoroalkyl groups having 1 to 5 carbon atoms, nitrile group, alkoxycarbonyl groups having 1 to 5 carbon atoms, acyl groups having 1 to 5 carbon atoms, alkylsulfonyl groups having 1 to 9 carbon atoms, arylsulfonyl groups having 6 to 9 carbon atoms, alkylsulfinyl groups having 1 to 9 carbon atoms, arylsulfinyl groups having 6 to 9 carbon atoms, arylcarbonyl groups having 6 to 9 carbon atoms, thiocarbonyl group, fluorine-containing alkyl groups having 1 to 9 carbon atoms, fluorine-containing aryl groups having 6 to 9 carbon atoms, fluorine-containing aryl groups having 3 to 9 carbon atoms, oxo group and halogen elements.

More preferred electron-attractive groups are selected from the group consisting of nitro group, fluoroalkyl groups having 1 to 5 carbon atoms, nitrile group, alkoxycarbonyl groups having 1 to 5 carbon atoms, acyl groups having 1 to 5 carbon atoms, arylsulfonyl groups having 6 to 9 carbon atoms, arylcarbonyl groups having 6 to 9 carbon atoms, oxo group and halogen elements.

Examples of the compounds represented by general formulae (L-I) and (L-II) will be given below, which by no means limit the compounds in the present invention.

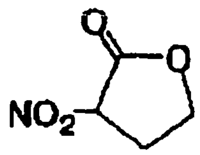
(LI-1)

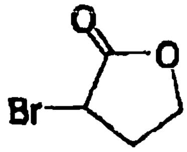
(LI-2)

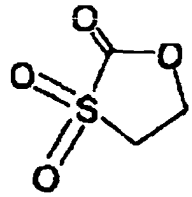
(LI-3)

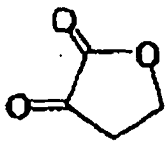
(LI-4)

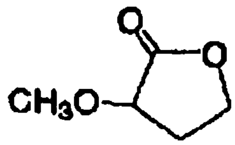
(LI-5)

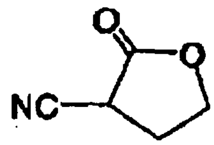
(LI-6)

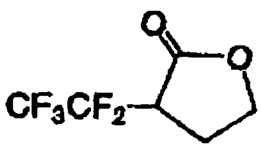
(LI-7)

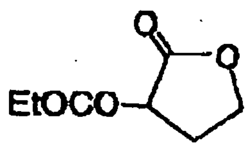
(LI-8)

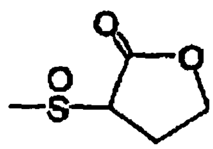
(LI-9)

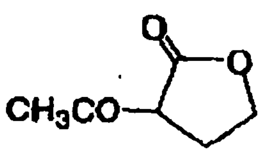
(LI-10)

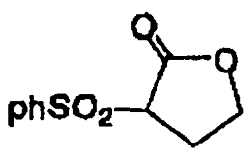
(LI-11)

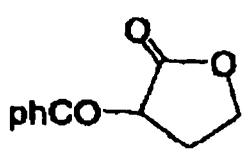
(LI-12)

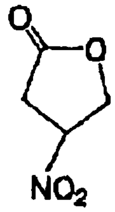
(LI-13)

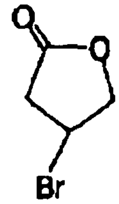
(LI-14)

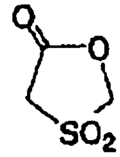
(LI-15)

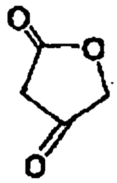
(LI-16)

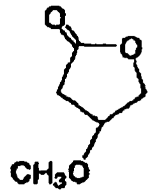
(LI-17)

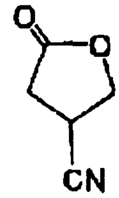
(LI-18)

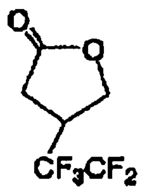
(LI-19)

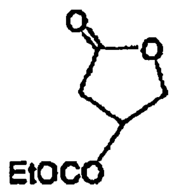
(LI-20)

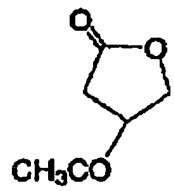
(LI-21)

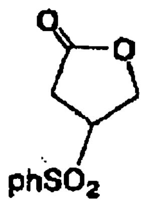
(LI-22)

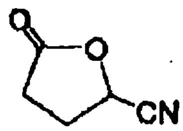
(LI-23)

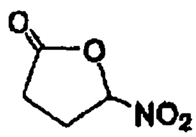
(LI-24)

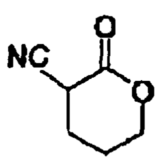
(LII-1)

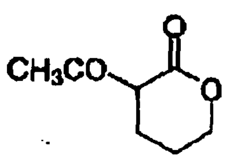
(LII-2)

The amount of the compounds of general formulae (L-I) and (L-II) is preferably 0.1 to 50 mass %, more preferably 1 to 30 mass %, based on the total solid components in the image-forming layer. When the amount is at least 0.1 mass %, a sufficient effect can be obtained and when it is not larger than 50 mass %, the image-forming property is not insufficient. It is desired that this compound is selectively brought into contact with the developer because it reacts with the developer.
The lactone compounds may be used either alone or in the form of a combination of two or more of them. Two or more compounds of the general formula (L-I) or two or more compounds of the general formula (L- II) may be used together in any proportion so that the total of them is within the above-described range.

(A-3) Abrasion resistance improvers

An abrasion resistance improver can be used for the purposes of improving the solution resistance of the surface of the image-forming layer and also strengthening the resistance of the surface to abrasion (abrasion resistance). The abrasion resistance improvers are, for example, polymers obtained by polymerizing (meth)acrylate monomers having 2 or 3 perfluoroalkyl groups having 3 to 20 carbon atoms in the molecule as described in J. P. KOKAI No. 2000-187318.
The amount of the abrasion resistance improver is preferably 0.1 to 10 mass %, more preferably 0.5 to 5 mass %, based on the materials composing the image-forming layer.

(A-4) Others

For improving the inhibition of the solution of the image regions in the developer, it is desirable to use a substance which is decomposable by heat and which substantially reduces the solubility of alkaline water-soluble polymer compounds while it is not decomposed. Those substances are, for example, onium salts, quinine diazides, aromatic sulfone compounds and aromatic sulfonic acid ester compounds.

(A-4-1) Onium salts

Onium salts are, for example, diazonium salts, ammonium salts, phosphonium salts, iodonium salts, sulfonium salts, selenonium salts and arsonium salts.
Preferred onium salts in the present invention are, for example, diazonium salts described in S. I. Schlesinger, Photogr. Sci. Eng., 18, 387 (1974), T. S. Balet al., Polymer, 21, 423 (1980) and J. P. KOKAI No. Hei 5-158230, ammonium salts described in U. S. Patent Nos. 4,069,055 and 4,069,056 and J. P. KOKAI Hei 3-140140, phosphonium salts described in D. C. Necker et al., Macromolecules, 17, 2468 (1984), C. S. Wen et al., Teh, Proc. Conf. Rad. Curing ASIA, p. 478 Tokyo, Oct. (1988) and U. S. Patent Nos. 4,069,055 and 4,069,056, iodonium salts described in J. V Crivello et al., Macromorecules, 10(6), 1307 (1977), Chem. & Eng. News, Nov. 28, p. 31 (1988), European Patent No. 104,143, U. S. Patent Nos. 339,049 and 410,201 and J. P. KOKAI Nos. Hei 2-150848 and 2-296514, sulfonium salts described in J. V Crivello et al., Polymer J. 17, 73 (1985), J. V Crivello et al., J. Org. Chem., 43, 3055 (1978), W R. Watt et al., J. Polymer Sci., Polymer Chem. Ed., 22, 1789 (1984), J. V Crivello et al., Polymer Bull., 14, 279 (1985), J. V Crivello et al., Macromorecules, 14 (5), 1141 (1981), J. V Crivello et al., J. Polymer Sci., Polymer Chem. Ed., 17, 2877 (1979), European Patent Nos. 370,693, 233,567, 297,443 and 297,442, U. S. Patent Nos. 4,933,377, 3,902,114, 410,201, 339,049, 4,760,013, 4,734,444 and 2,833,827 and German Patent Nos. 2,904,626, 3,604,580 and 3,604,581, selenonium salts described in J. V Crivello et al., Macromorecules, 10 (6), 1307 (1977) and J. V Crivello et aL, J. Polymer Sci, Polymer Chem. Ed., 17, 1047 (1979), and arsonium salts described in C. S. Wen et al., Teh, Proc. Conf. Rad. Curing ASIA, p. 478, Tokyo, Oct. (1988). In the onium salts, diazonium salts are particularly preferred. Particularly preferred diazonium salts are those described in J. P KOKAI No. Hei 5-158230.
Counter ions to the onium salts are, for example, tetrafluoroboric acid, hexafluorophosphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4-hydroxy-5-benzoyl-benzenesulfonic acid and p-toluenesulfonic acid. In those compounds, hexafluorophosphoric acid and alkyl-aromatic sulfonic acids such as triisopropylnaphthalenesulfonic acid and 2,5-dimethylbenzenesulfonic acid are particularly preferred.

(A-4-2) Quinone diazides

Preferred quinone diazides include o-quinone diazide compounds. O-Quinone diazide compounds used in the present invention are those having at least one o-quinonediazido group and an alkali solubility which is increased

by the thermal decomposition. O-Quinone diazide compounds having various structures are usable. Namely, the solubility of the image-forming layer is improved by two effects of o-quinone diazides. Namely, the effects are that o-quinone diazides lose the effect of inhibiting the solution of the binder by the thermal decomposition and that o-quinone diazides themselves are converted into alkali-soluble substances. The o-quinone diazide compounds usable in the present invention are, for example, those described on pages 339 to 352 of J. Kosar "Light-sensitive Systems" (John Wiley & Sons Inc.). Sulfonic acid esters or sulfonic acid amides of o-quinone diazides obtained by the reaction with various aromatic polyhydroxy-compounds or aromatic amino compounds are particularly preferred. Preferred o-quinone diazide compounds also include esters of benzoquinone (1,2)-diazidosulfonic acid chloride or naphthoquinone-(1,2)-diazido-5-sulfonic acid chloride with pyrogallol-acetone resin as described in J. P. KOKOKU No. Sho 43-28403 and esters of benzoquinone-(1,2)-diazidosulfonic acid chloride or naphthoquinone-(1,2)-diazido-5-sulfonic acid chloride with phenol-formaldehyde resin.

Further, esters of naphthoquinone-(1,2)-diazido-4-sulfonic acid chloride with phenol-formaldehyde resin or with cresol-formaldehyde resin and also esters of naphthoquinone-(1,2)-diazido-4-sulfonic acid chloride with pyrogallol-acetone resin are also preferably used. Other useful o-quinone diazide compounds are known from the specifications of many patents such as J. P. KOKAI Nos. Sho 47-5303, Sho 48-63802, Sho 48-63803, Sho 48-96575, Sho 49-38701 and Sho 48-13354, J. P. KOKOKU Nos. Sho 41-11222, Sho 45-9610 and Sho 49-17481, U. S. Patent Nos. 2,797,213, 3,454,400, 3,544,323, 3,573,917, 3,674,495 and 3,785,825, British Patent Nos. 1,227,602, 1,251,345, 1,267,005, 1,329,888 and 1,330,932, and German Patent No. 854,890.

The amount of the o-quinone diazide compound is preferably 1 to 50 mass %, more preferably 5 to 30 mass % and particularly preferably 10 to 30 mass % based on the total solids in the image-forming layer. These compounds are usable either alone or in the form of a mixture of some of them.

(B) Development accelerators

Development accelerators can be used for further improving the sensitivity. The development accelerators are, for example, acid anhydrides, phenols and organic acids.

The acid anhydrides are preferably cyclic acid anhydrides. Concretely, the acid anhydrides usable herein are, for example, phthalic anhydride, tetrahydrophthalic anhydride, hexahydrophthalic anhydride, 3,6-endoxytetrahydrophthalic anhydride, tetrachlorophthalic anhydride, maleic anhydride, chloromaleic anhydride, $\alpha$-phenylmaleic anhydride, succinic anhydride and pyromellitic anhydride described in U. S. Patent No. 4,115,128. Acyclic acid anhydrides include, for example, acetic anhydride.

The phenols are, for example, bisphenol A, 2,2'-bishydroxysulfone, p-nitrophenol, p-ethoxyphenol, 2,4,4'-trihyroxybenzophenone, 2,3,4-trihydroxybenzophenone, 4-hydroxybenzophenone, 4,4',4"-trihydroxytriphenylmethane and 4,4',3",4"-tetrahydroxy-3,5,3',5'-tetramethyltriphenylmethane.

The organic acids are, for examples, sulfonic acids, sulfinic acids, alkylsulfuric acids, phosphonic acids, phosphoric esters and carboxylic acids described in J. P. KOKAI Nos. Sho 60-88942, Hei 2-96755, etc. Concretely, they include p-toluenesulfonic acid, dodecylbenzenesulfonic acid, p-toluenesulfinic acid, ethylsulfunic acid, phenylphosphonic acid, phenylphosphinic acid, phenyl phosphate, diphenyl phosphate, benzoic acid, isophthalic acid, adipic acid, p-toluylic acid, 3,4-dimethoxybenzoic acid, phthalic acid, terephthalic acid, 4-cyclohexene-1,2-dicarboxylic acid, erucic acid, lauric acid, n-undecanoic acid and ascorbic acid.

The relative amount of the development accelerator to the image-forming layer is preferably 0.05 to 20 mass %, more preferably 0.1 to 15 mass % and particularly preferably 0.1 to 10 mass %.

(C) Surfactants

For improving the coating property and also for broadening the developing conditions for the stable process, the image-forming layer can further contain nonionic surfactants described in J. P. KOKAI Nos. Sho 62-251740 and Hei 3-208514, amphoteric surfactants described in J. P. KOKAI Nos. Sho 59-121044 and Hei 4-13149, siloxane compounds described in EP No. 950517, and copolymers of fluorine-containing monomers described in J. P. KOKAI Nos. Sho 62-170950 and Hei 11-288093 and Japanese Patent Application No. 2001-247351.

The nonionic surfactants are, for example, sorbitan tristearate, sorbitan monopalmitate, sorbitan trioleate, stearoyl monoglyceride and polyoxyethylene nonylphenyl ether.

The amphoteric surfactants are, for example, alkyldi(aminoethyl)glycines, alkylpolyaminoethylglycine hydrochlorides, 2-alkyl-N-carboxyethyl-N-hydroxyethylimidazoliniumbetaines and N-tetradecyl-N,N-betains [for example, Amorgen K (trade name of Dai-ichi Kogyo Co., Ltd.)].

As the siloxane compounds, block copolymers of dimethylsiloxane and a polyalkylene oxide are preferred. Examples of them include polyalkylene oxide-modified silicones such as DBE-224, DBE-621, DBE-712, DBP-732 and DBP-534 of Chisso Corporation and Tego Glide 100 of Tege Co. (Germany).

The relative amount of the surfactant to the image-forming layer is preferably 0.01 to 15 mass %, more preferably 0.1 to 5 mass % and most preferably 0.05 to 0.5 mass %.

(D) Printing-out agents

A printing-out agent for obtaining a visible image immediately after the heating by the exposure and a dye or pigment as the image-coloring agent can be added to the image-forming layer in the heat-sensitive lithographic printing plate precursor

Typical printing-cut agents are combinations of a compound which releases an acid by heating by the exposure (light acid-releasing agent) and an organic dye capable of forming a salt. Examples of the printing-out agents include a combination of an o-naphthoquinonediazido-4-sulfonic acid halide and a salt-forming organic dye described in J. P. KOKAI Nos. Sho 50-36209 and 53-8128, and a combination of a trihalomethyl compound and a salt-forming organic dye described in J. P. KOKAI Nos. Sho 53-36223, 54-74728, 60-3626, 61-143748, 61-151644 and 63-58440. The trihalomethyl compounds include trihalomethyloxazole compounds and trihalomethyltriazine compounds. Both of them are excellent in storability and they yield clear printed images.

(E) Coloring agents

Other dyes can be used in addition to the above-described salt-forming organic dyes as the coloring agents for images. Preferred dyes including the salt-forming organic dyes are oil-soluble dyes and basic dyes. Concretely, they include Oil Yellow #101, Oil Yellow #103, Oil Pink #312, Oil Green BG, Oil Blue BOS, Oil Blue #603, Oil Black BY, Oil Black BS and Oil Black T-505 (products of Orient Chemical Industry Co., Ltd.), Victoria Pure Blue, Crystal Violet Lactone, Crystal Violet (CI 42555), Methyl Violet (CI 42535), Ethyl Violet, Rhodamine B (CI 145170B), Malachite Green (CI 42000) and Methylene Blue (CI 52015). Dyes described in J. P. KOKAI No. Sho 62-293247 are particularly preferred.

The colorant can be used in an amount of 0.01 to 10 mass %, preferably 0.1 to 3 mass %, based on the total solids in the image-forming layer.

(F) Plasticizers

If necessary, a plasticizer is added to the image-forming layer in the heat-sensitive lithographic printing plate precursor for the purpose of imparting a softness to the coating film in the present invention. The plasticizers are, for example, butyl phthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate and oligomers and polymers of acrylic acid and methacrylic acid

(G) waxes

A compound for lowering the static friction coefficient of the surface can be added to the image-forming layer of the heat-sensitive lithographic printing plate precursor for the purpose of imparting a resistance to abrasion. Concretely, the waxes are, for example, long chain alkylcarboxylic acid esters as used in U. S. Patent No. 6,117,913 and Japanese Patent Application Nos. 2001-261627, 2002-032904 and 2002-165584.

The amount of the wax is 0.1 to 10 mass %, preferably 0.5 to 5 mass %, based on the materials forming the image-forming layer.

(3-2-4) Solvents

The image-forming layer of the heat-sensitive lithographic printing plate precursor can be formed by dissolving the components described in above paragraphs (3-2-1) to (3-2-3) in a solvent and applying the obtained solution to the above-described substrate (3-1).

The solvents usable herein are, for example, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, $\gamma$ -butyrolactone and toluene. However, those examples do not limit the solvents usable herein. These solvents are used either alone or in the form of a mixture of them.

In the formation of the image-forming layer having a laminate structure, the solvent selected for the coating is preferably as follows: The solubility of the alkali-soluble polymer used for forming the upper heat-sensitive layer is different from that of the alkali-soluble polymer used for forming the under layer. It is also possible to positively conduct the partial mutual solution for imparting a new function.

Methods for separately forming the two layers include, for example, a method performed by taking advantage of a difference in the solubility of the copolymer to be contained in the under layer and the alkali-soluble resin to be contained in the upper heat-sensitive layer in the solvent, and a method wherein the upper heat-sensitive layer is formed by coating and then the solvent is rapidly dried and removed. These methods will be described in detail below, which by no means limit the methods for separately forming the two layers.

In the method completed by taking advantage of a difference in the solubility of the copolymer to be contained in the under layer and the resin soluble in the aqueous alkali solution to be contained in the upper heat-sensitive layer in the solvent, the solvent is selected so that the specified copolymer contained in the under layer and the copolymer used together with it are insoluble in this solvent. By selecting such a solvent, the respective layers can be completely free from being mixed after the forming of the two coated layers. For example, the formation of the two layers is made possible by selecting a copolymer comprising specified monomers constituting the under layer as copolymerizable components and insoluble in solvents in which resins soluble in aqueous alkali solutions such as methyl ethyl ketone and 1-methoxy-2-propanolare soluble, forming the under layer mainly comprising the copolymer by coating with a solvent in which the copolymer constituting the under layer is soluble, drying the under layer and then forming the upper heat-sensitive layer mainly comprising the resin soluble in the aqueous alkali solution by coating by using a solvent, in which the under layer components are insoluble, such as methyl ethyl ketone or 1-methoxy-2-propanol.

The second layer can be rapidly dried immediately after forming the layer by coating by a method wherein high-pressure air is blown against the layer through a slit nozzle placed almost at right angle to the web-running direction, by applying a heat energy as the conducted heat through the lower surface of the web from rolls (heating rolls) having a heating medium such as vapor therein, or by combining these two methods.

Methods for partially compatibilize the two layers on such a level that the effect of the present invention can be sufficiently exhibited include a method wherein the difference in the solubility of the two layers in the solvent is utilized and a method wherein the solvent is extremely rapidly dried after the formation of the second layer. The purpose can be attained by controlling the degree of the difference in the first method and also controlling the degree of the difference in the rapidness of the drying.

The coating solution to be applied to the substrate for forming the image-forming layer is formed by dissolvent the components described in above items (3-2-1) to (3-2-3) in a suitable solvent. The concentration of the components (total solid components including the additives) in the solvent is preferably 1 to 50 mass %. Methods for the coating are various and they include, for example, bar coater coating method, rotation coating method, spray coating method, curtain coating method, dip coating method, air knife coating method, blade coating method and roll coating method.

In the formation of the image-forming layer having a laminate structure, it is desirable that the upper heat-sensitive layer is formed by non-contact method so as to prevent a damage of the under layer in this forming step. It is also possible to employ a contact method, i. e. bar coating method as generally employed in the solvent coating process. In this case, the coating is desirably conducted by the forward rotating drive for preventing the under layer from damages.

The amount (solid) of the dry image-forming layer formed by the coating and drying on the substrate is generally 0.5 to 5.0 $g/m^2$.

When the image-forming layer has the laminate structure, the amount of the under layer is preferably in the range of 0.5 to 4.0 $g/m^2$ and more preferably 0.6 to 2.5 $g/m^2$. When the amount of the under layer is not smaller than 0.5 $g/m^2$, the printing durability is not damaged and, on the other than, when it is not larger than 4.0 $g/m^2$, the excellent image reproducibility and sensitivity can be obtained. The amount of the upper heat-sensitive layer is preferably in the range of 0.05 $g/m^2$ to 1.0 $g/m^2$, more preferably in the range of 0.08 $g/m^2$ to 0.7 $g/m^2$. When the amount of this upper heat-sensitive layer is not smaller than 0.05 $g/m^2$, the development latitude and abrasion resistance are not lowered and when it is not larger than 1.0 $g/m^2$, a good sensitivity is obtained. The total amount of the under layer and upper layer is preferably in the range of 0.6 $g/m^2$ to 4.0 $g/m^2$, more preferably in the range of 0.7 $g/m^2$ to 2.5 $g/m^2$. When the total amount is not smaller than 0.6 $g/m^2$, the printing durability is not damaged and, on the other than, when it is not larger than 4.0 $g/m^2$, the excellent image reproducibility and sensitivity can be obtained.

(3-3) Under layer

The heat-sensitive positive-working lithographic printing plate precursor used in the present invention can have a subbing layer between the substrate and the image-forming layer or, when two image-forming layers are provided, between the substrate and the under image forming layer.

Various organic compounds are used as the components of the subbing layer. The organic compounds are, for example, carboxymethyl cellulose, dextrin, gum arabic, phosphonic acids having amino group such as 2-aminoethylphosphonic acid, organic phosphonic acids which may have a substituent such as naphthylphosphonic acid, alkylphosphoniacids, glycerophosphonic acid, methylenediphosphonic acid and ethylenediphosphonic acid, organic phosphoric acids which may have a substituent such as phenylphosphoric acid, naphthylphosphoric acid, alkylphosphoric

acid and glycerophosphoric acid, organic phosphinic acids which may have a substituent such as phenylphosphinic acid, naphthylphosphinic acid, alkylphosphinic acids and glycerophosphinic acid, amino acids such as glycine and β -alanine, and hydrochlorides of hydroxyl group-containing amines such as triethanolamine hydrochloride. They may be used either alone or in the form of a mixture of two or more of them.

The organic subbing layer can be formed by the following method: a solution of the above-described organic compound in water or an organic solvent such as methanol, ethanol or methyl ethyl ketone or a mixture of these solvents is applied to an aluminum sheet and then dried. In another method, an aluminum sheet is immersed in a solution of the above-described organic compound in water or an organic solvent such as methanol, ethanol or methyl ethyl ketone or a mixture of these solvents to adsorb the compound on the film and then the film is washed with water or the like and dried to form the organic subbing layer. In the former method, a 0.005 to 10 mass % solution of the above-described organic compound can be applied in various methods. In the latter method, the concentration of the solution is 0.01 to 20 mass %, preferably 0.05 to 5 mass %, the immersion temperature is 20 to 90°C, preferably 25 to 50°C, and the immersion time is 0.1 second to 20 minutes, preferably 2 seconds to 1 minute. pH of the solution used in this step can be adjusted to 1 to 12 with a basic substance such as ammonia, triethylamine or potassium hydroxide or an acidic substance such as hydrochloric acid or phosphoric acid. A yellow dye can be used for improving the tone reproduction in the image-forming layer.

The amount of the organic subbing layer is 2 to 200 mg/$m^2$, preferably 5 to 100 mg/$m^2$. When the amount of this layer is not smaller than 2 mg/$m^2$, or not larger than 200 mg/$m^2$, a sufficient printing durability can be obtained.

Examples

The following Examples will further illustrate the present invention, which by no means limit the scope of the invention.

[Preparation of lithographic printing plate precursor]

Preparation of positive-working lithographic printing plate precursors 1 and 2:

[Preparation of aluminum base 1]

An aluminum base to be used as a substrate having the hydrophilic surface was prepared as described below.

An aluminum plate (grade: 1050) having a thickness of 0.3 mm was defatted by washing with trichloroethylene. Then the surface was sand-blasted with a nylon brush and an aqueous suspension of 400 mesh pumice stone and then thoroughly washed with water. The plate was then etched by the immersion in 25 % aqueous sodium hydroxide solution at 45°C for 9 seconds. After washing with water, the aluminum plate was immersed in 20 % nitric acid for 20 seconds and then washed with water. In this step, the amount of the etching of the sand-blasted surface was about 3 g/$m^2$. Then 3 g/$m^2$ direct current anodized film was formed thereon by using 7 % sulfuric acid as the electrolyte at a current density of 15 A/$dm^2$. After washing with water and drying, the film was further treated with 2.5 mass % aqueous sodium silicate solution at 30°C for 10 seconds. A coating solution for the subbing layer as described below was applied thereto and the coating film was dried at 80°C for 15 seconds to obtain aluminum base 1. The amount of the coating after drying was 15 mg/$m^2$.

[Preparation of aluminum base 2]

An aluminum plate (grade: JIS A 1050) having a thickness of 0.3 mm was etched under conditions comprising sodium hydroxide concentration of 30 g/liter, aluminum ion concentration of 10 g/liter and liquid temperature of 60°C for 10 seconds. The plate was washed with running water, then washed and neutralized with 10 g/l nitric acid and then washed with water. Then the plate surface was electrochemically roughened with 500 C/$dm^2$ sine wave of alternate current in an aqueous solution having a hydrogen chloride concentration of 15 g/l, aluminum ion concentration of 10 g/l and a temperature of 30°C under conditions of applied voltage Va of 20 V, and washed with water. Then the plate surface was etched under conditions comprising sodium hydroxide concentration of 30 g/l, aluminum ion concentration of 10 g/l and liquid temperature of 40°C for 10 seconds, and then washed with running water. After desmutting treatment in 10 mass % aqueous sulfuric acid solution having a sulfuric acid concentration of 15 mass % and solution temperature of 30°C, the plate was washed with water. Then the plate was subjected to anodic oxidation in 10 mass % aqueous sulfuric acid solution having a temperature of 20°C under conditions of direct current at a current density of 6 A/$dm^2$ so as to obtain 2.5 g/$m^2$ of an anodic oxide film. The film was then washed with water, dried and treated with 2.5 mass % aqueous sodium silicate solution at 30°C for 10 seconds to obtain the base. The center line average roughness (Ra) of the base was 0.48 μm as determined with a needle having a diameter of 2 μm. A coating mixture for subbing

layer having a composition shown below was applied to the silicate-treated aluminum base and then dried at 80°C for 15 seconds to form a coating film. After drying, the amount of the coating film was 17 mg/m2. Aluminum base 2 was thus obtained.

| <Coating liquid for subbing layer> | |
|---|---|
| Copolymer P shown below (molecular weight: 28000) | 0.3 g |
| Methanol | 100 g |
| Water | 1g |

Copolymer P

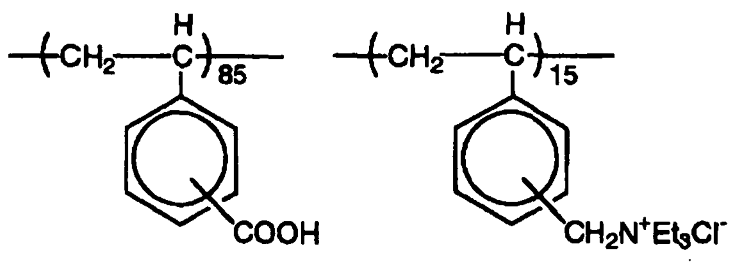

Synthesis Example 1 [Synthesis of B1 component: alkali-soluble polymer compound (copolymer) having carboxyl group]

2.39 g (0.021 mol) of ethyl methacrylate, 2.98 g (0.021 mol) of isobutyl methacrylate, 1.55 g (0.018 mol) of methacrylic acid and 20 g of 1-methoxy-2-propanol were fed into a 20 ml three-necked flask provided with a stirrer, a condenser and a dropping funnel. The obtained mixture was stirred under heating at 65°C in a hot water bath. 0.15 g of "V-601" (a product of Wako Pure Chemical Industries, Ltd) was added to the mixture, and they were stirred in nitrogen stream for 2 hours while the temperature was kept at 70°C. A mixture of 2.39 g (0.021 mol) of ethyl methacrylate, 2.98 g (0.021 mol) of isobutyl methacrylate, 1.55 g (0.018 mol) of methacrylic acid, 20 g of 1-methoxy-2-propanol and 0.15 g of "V-601" was added dropwise to the reaction mixture through a dropping funnel for 2 hours. After completion of the addition, 40 g of methanol was added to the mixture and they were cooled. The obtained mixture was added to 2 liters of water while the water was stirred. After stirring the mixture for 30 minutes, precipitates thus formed were taken by the filtration and then dried to obtain 15 g of a white solid.
The mass average molecular weight (standard: polystyrene) of the copolymer was 53,000 as determined by the gel permeation chromatography.

Synthesis Example 2 (Synthesis of B1 component: polyurethane resin having carboxyl group)

14.6 g (0.109 mol) of 2,2-bis(hydroxymethyl)propionic add, 13.3 g (0.0686 mol) of tetraethylene glycol and 2.05 g (0.0228 mol) of 1,4-butanediol were fed into a three-necked round-bottom flask provided with a condenser and a stirrer. They were dissolved in 118 g of N,N-dimethyl acetamide. 30.8 g (0.123 mol) of 4,4'-diphenyhnethane diisocyanate, 13.8 g (0.0819 mol) of hexamethylene diisocyanate and 0.1 g of n-butyltin dilaurate as the catalyst were added thereto, and they were heated at 90°C under stirring for 7 hours.
100 ml of N,N-dimethylacetamide, 50 ml of methanol and 50 ml of acetic acid were added to the reaction mixture, and they were stirred and then added to 4 liters of water under stirring to form a white polymer. The polymer was taken by the filtration, washed with water and dried under reduced pressure to obtain 60 g of a polymer.
The polymer had a mass average molecular weight (standard: polystyrene) of 70,000 as determined by the gel permeation chromatography. Carboxyl group content as determined by the titration was 1.43 meq/g.

Synthesis Example 3

31.0 g (0.36 mol) of methacrylic acid, 39.1 g (0.36 mol) of ethyl chloroformate and 200 ml of acetonitrile were fed into a 500 ml three-necked flask provided with a stirrer, a condenser and a dropping funnel. The obtained mixture was stirred under cooling in an ice/water bath. 36.4 g (0.36 mol) of triethylamine was added dropwise to the mixture through a dropping funnel for about 1 hour. After the completion of the dropping, the ice/water bath was removed and

the mixture was stirred at room temperature for 30 minutes. 51.7 g (0.30 mol) of p-aminobenzenesulfonamide was added to the reaction mixture, and they were stirred under heating at 70°C in an oil bath for 1 hour. After completion of the reaction, the mixture was added to 1 liter of water while the water was stirred. The obtained mixture was stirred for 30 minutes. The mixture was filtered to take the precipitates, which were then added to 500 ml of water to obtain a slurry. The slurry was filtered and the obtained solid was dried to obtain N-(p-aminosulfonylphenyl)methacrylamide in the form of a white solid (yield: 46.9 g).

Then 4.61 g (0.0192 mol) of N-(p-aminosulfonylphenyl)methacrylamide, 2.94 g (0.0258 mol) of ethyl methacrylate, 0.80 g (0.015 mol) of acrylonitrile and 20 g of N,N-dimethylacetamide were fed into a 20 ml three-necked flask provided with a stirrer, a condenser and a dropping funnel, and they were stirred under heating at 65°C in a hot water bath. 0.15 g of "V-65" (a product of Wako Pure Chemical Industries, Ltd.) was added to the mixture, and they were stirred in nitrogen stream for 2 hours while the temperature was kept at 65°C. A mixture of 4.61 g of N-(p-aminosulfonylphenyl)methacrylamide, 2.94 g of ethyl methacrylate, 0.80 g of acrylonitrile, N,N-dimethylacetamide and 0.15 g of "V-65" was added dropwise to the reaction mixture through a dropping funnel during 2 hours. After completion of the addition, the mixture was stirred at 65°C for 2 hours. After completion of the reaction, 40 g of methanol was added to the mixture and they were cooled. The obtained mixture was added to 2 liters of water while the water was stirred. After stirring the mixture for 30 minutes, precipitates thus formed were taken by the filtration and then dried to obtain 15 g of a white solid. The mass average molecular weight (standard polystyrene) of the copolymer was 53,000 as determined by the gel permeation chromatography.

A coating mixture for forming the image-forming layer shown below was applied to the aluminum base 1 and aluminum base 2 obtained as described above, and they were dried at 150°C for 30 seconds to obtain a dry coating amount of 1.8 g/m$^2$, thereby obtaining positive-working lithographic printing plate precursor 1 and positive-working lithographic printing plate precursor 2.

| <Coating mixture for image-forming layer> | |
|---|---|
| Copolymer of Synthesis Example 1 | 0.050 g |
| Copolymer of Synthesis Example 2 | 0.050 g |
| Copolymer of Synthesis Example 3 | 0.4 g |
| m, p-cresol novolac (m/p ratio = 6/4, mass average molecular weight: 8000, containing 0.5 % of unreacted cresol) | 0.6 g |
| Cyanine dye A (having a structure shown below) | 0.1 g |
| Phthalic anhydride | 0.05 g |
| p-Toluenesulfonic acid | 0.002 g |
| Ethyl violet (counter ion: 6-hydroxy- β -naphthalenesulfonic acid) | 0.02 g |
| Ester of naphthoquinone 1,2-diazide-5-sulfonyl chloride and pyrogallol / acetone resin | 0.01 g |
| Fluorine surfactant (Trade name: Megafac F-177, a product of Dainippon Ink and Chemicals, Inc.) | 0.05 g |
| Methyl ethyl ketone | 8 g |
| 1-Methoxy-2-propanol | 4 g |

Cyanine dye A

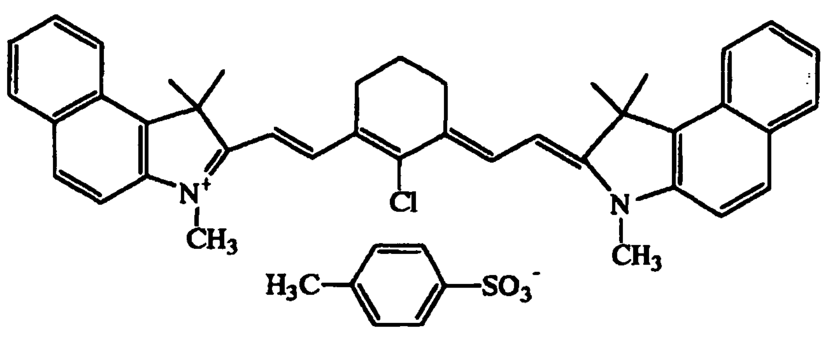

Preparation of positive-working lithographic printing plate precursors 3 and 4:

0.85 g/m$^2$ of a coating mixture for forming an under layer which will be described below was applied to each of the above-described web-formed aluminum bases 1 and 2 with a bar coater and then dried at 160°C for 44 seconds. Immediately thereafter, they were cooled with cold air of 17 to 20°C until the temperature of the substrate was lowered to 35°C. 0.22 g/m$^2$ of a coating mixture for forming upper heat-sensitive layer which will be described below was applied thereto with a bar coater, then dried at 148°C for 25 minutes and then slowly dried with air having a temperature of 20 to 26°C to obtain the positive-working lithographic printing plate precursor 3 and the positive-working lithographic printing plate precursor 4.

| [Coating mixture for forming under layer] | |
|---|---|
| N-(4-Aminosulfonylphenyl)methacrylamide / acrylonitrile / Methyl methacrylate (36/34/30: mass average molecular weight: 50000, acid value: 2.65) | 2.133 g |
| Cyanine dye A (having a structure shown below) | 0.134 g |
| 4,4'-Bishyroxyphenylsulfone | 0.126 g |
| Tetrahydrophthalic anhydride | 0.190 g |
| p-Toluenesulfonic acid | 0.008 g |
| 3-Methoxy-4-diazodiphenylamine hexafluorophosphate | 0.032 g |
| Ethyl Violet having a counter ion converted to 6-hydroxy-naphthalenesulfonic acid | 0.781 g |
| Megafac F 176 (Dainippon Ink and Chemicals, Inc.) (a fluorine surfactant for improving the condition of the coated surface) | 0.035 g |
| Methyl ethyl ketone | 25.41 g |
| 1-Methoxy-2-propanol | 12.97 g |
| γ-Butyrolactone | 13.18 g |

Cyanine dye A

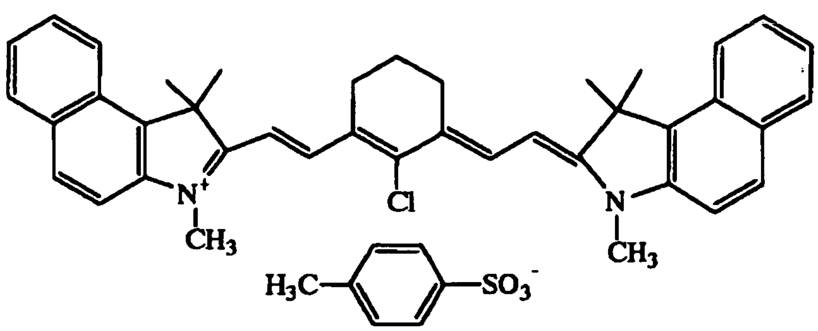

| [Coating mixture for upper heat-sensitive layer] | |
|---|---|
| m,p-Cresol Novolac (m/p ratio = 6/4, mass average molecular weight: 4500, unreacted cresol content: 0.8 mass %) | 0.3479 g |
| Cyanine dye A | 0.0192 g |
| Ethyl methacrylate / isobutyl methacrylate / acrylic acid copolymer (37/37/26 wt. %) 30 % MEK solution | 0.1403 g |

(continued)

| [Coating mixture for upper heat-sensitive layer] | |
|---|---|
| Megafac F 780F (30 %) (Dainippon Ink and Chemicals, Inc.) (a surfactant for improving the condition of the surface) | 0.015 g |
| Megafac F 781F (Dainippon Ink and Chemicals, Inc.) | 0.00328 g |
| Methyl ethyl ketone | 13.07 g |
| 1-Methoxy-2-propanol | 6.79 g |

Example 1

[Preparation of relationship $\alpha$ 1]

A contact print image was formed on each of many lithographic printing plate precursors 1 to 4 obtained as described above with Trendsetter of Creo Co. under conditions of beam strength range of 2 to 10 W and drum-rotating speed of 150 rpm, and exposed to form the image.

Developers 1 to 50 having different development inhibitor concentration and different alkali strength were prepared by varying the concentration of polyethylene glycol used as the development inhibitor and potassium hydroxide used as the alkali. Each developer was fed into an immersion-type developing tank of an automatic developing machine (improved PS Processor LP940H, Fuji Photo Film Co., Ltd.) and the lithographic printing plate precursors were subjected to the development process at a temperature kept at 30°C.

| Composition 1 of developers 1 to 50 | |
|---|---|
| D-sorbitol | 0.22 mol/L |
| Potassium hydroxide | Table 1 |
| Polyethylene glycol (mass average molecular weight: 600, Development inhibitor) | Table 1 |
| Anionic surfactant [compound (A-3) in (2-4) in this Specification] | 0.25 g/L |

Table 1

| Composition 2 of developers 1 to 50 | | | | | |
|---|---|---|---|---|---|
| | Conc. of development inhibitor (g/L) | Conc. of potassium hydroxide (mol/L) | | Conc. of development inhibitor (g/L) | Conc. of potassium hydroxide (mol/L) |
| 1 | 0.1 | 0.15 | 26 | 0.1 | 0.275 |
| 2 | 0.15 | 0.15 | 27 | 0.15 | 0.275 |
| 3 | 0.2 | 0.15 | 28 | 0.2 | 0.275 |
| 4 | 0.25 | 0.15 | 29 | 0.25 | 0.275 |
| 5 | 0.3 | 0.15 | 30 | 0.3 | 0.275 |
| 6 | 0.1 | 0.175 | 31 | 0.1 | 0.30 |
| 7 | 0.15 | 0.175 | 32 | 0.15 | 0.30 |
| 8 | 0.2 | 0.175 | 33 | 0.2 | 0.30 |
| 9 | 0.25 | 0.175 | 34 | 0.25 | 0.30 |
| 10 | 0.3 | 0.175 | 35 | 0.3 | 0.30 |
| 11 | 0.1 | 0.20 | 36 | 0.1 | 0.325 |
| 12 | 0.15 | 0.20 | 37 | 0.15 | 0.325 |
| 13 | 0.2 | 0.20 | 38 | 0.2 | 0.325 |
| 14 | 0.25 | 0.20 | 39 | 0.25 | 0.325 |
| 15 | 0.3 | 0.20 | 40 | 0.3 | 0.325 |

Table 1 (continued)

| Composition 2 of developers 1 to 50 | | | | | |
|---|---|---|---|---|---|
| | Conc. of development inhibitor (g/L) | Conc. of potassium hydroxide (mol/L) | | Conc. of development inhibitor (g/L) | Conc. of potassium hydroxide (mol/L) |
| 16 | 0.1 | 0.225 | 41 | 0.1 | 0.35 |
| 17 | 0.15 | 0.225 | 42 | 0.15 | 0.35 |
| 18 | 0.2 | 0.225 | 43 | 0.2 | 0.35 |
| 19 | 0.25 | 0.225 | 44 | 0.25 | 0.35 |
| 20 | 0.3 | 0.225 | 45 | 0.3 | 0.35 |
| 21 | 0.1 | 0.25 | 46 | 0.1 | 0.375 |
| 22 | 0.15 | 0.25 | 47 | 0.15 | 0.375 |
| 23 | 0.2 | 0.25 | 48 | 0.2 | 0.375 |
| 24 | 0.25 | 0.25 | 49 | 0.25 | 0.375 |
| 25 | 0.3 | 0.25 | 50 | 0.3 | 0.375 |

After the development process, each lithographic printing plate precursor was placed in a washing tank and washed while tap water was automatically fed. Then the plate was processed by passing it in a finishing tank containing 4 liters of a finishing solution prepared by diluting FG-1 (Fuji Photo Film Co., Ltd.) to 1/2 concentration with tap water. After the development process, the lithographic printing plate was macroscopically examined to determine the relationship between the development inhibitor concentration and alkali strength for obtaining a desired developing property while parts exposed to 4 W were completely dissolved and the image regions were kept undissolved

The relationship $\alpha$ 1-A between the development inhibitor concentration and alkali strength obtained with lithographic printing plate precursor 1 is shown in Fig. 1-A.

The relationship $\alpha$ 1-B between the development inhibitor concentration and alkali strength obtained with lithographic printing plate precursor 3 is shown in Fig. 1-B.

The lithographic printing plate precursor 2 is different from the lithographic printing plate precursor 1 in only the substrate and also the lithographic printing plate precursor 4 is different from the lithographic printing plate precursor 3 in only the substrate. Therefore, relationship $\alpha$ 1-A can be applied to the lithographic printing plate precursor 2 and also relationship $\alpha$ 1-B can be employed for the lithographic printing plate precursor 4. The relationship between the development inhibitor concentration (y) and the alkali strength (x) exponentially changes and it can be represented by the following approximate expression:

$$y = A \times e^{Bx}.$$

In the relationship $\alpha$ 1-A which can be applied to the plate precursors 1 and 2, A is $6 \times 10^{-25}$ and B is 4.16. In the relationship $\alpha$ 1-B which can be applied to the plate precursors 3 and 4, Ais $6 \times 10^{-71}$ and B is 12.36.

Separately from the above-described mixtures, an alkaline developer a1 and an alkaline replenisher b1 were prepared. With the alkaline developer a1, a desired developing property can be obtained. The alkaline replenisher b1 has a development inhibitor concentration and an alkali strength higher than those of a1.

| [Composition of alkaline developer a1] | |
|---|---|
| D-sorbitol | 0.22 mol/L |
| Potassium hydroxide | 0.22 mol/L |
| Potassium citrate | 18 g/L |
| Polyethylene glycol (mass average molecular weight: 600, development inhibitor) | 0.25 g/L |
| Anionic surfactant [compound (A-3) in (2-4) in this specification] | 0.25 g/L |

| [Composition of replenisher b1] | |
|---|---|
| D-sorbitol | 0.22 mol/L |
| Potassium hydroxide | 0.35 mol/L |
| Polyethylene glycol (mass average molecular weight: 600, development inhibitor) | 0.3 g/L |
| Anionic surfactant [compound (A-3) in (2-4) in this specification] | 0.3 g/L |

For determining the correction factor in the determination of a change in the alkali strength by the electroconductivity, carbon dioxide gas was blown into the developer a1 and replenisher b1 and the relationship between the alkali strength and the change of the electroconductivity was determined. The alkali strength was determined with a pH meter having glass electrodes. The lithographic printing plate precursor 1 was dissolved in the developer a1 and the replenisher b1, and the relationship between the alkalinity and the electroconductivity was determined The relationship between the alkalinity (x, $[OH^-]$ concentration, pH = -log ($10^{-14}/[OH^-]$) and electroconductivity (y) and also the correction factor are shown in Fig. 2.

Evaluation of development process

An ion electrode (nonionic surfactant electrode produced by Metrohm Shibata Co., Ltd.) and a reference electrode (Ag electrode) were arranged as a developer-sampling device and as a device for determining the development inhibitor concentration in a development tank of an automatic developing device (improved PS processor LP940H of Fuji Photo Film Co., Ltd.) so as to make the measurement of the development inhibitor concentration possible. Also an electroconductivity sensor was also arranged to make the determination of the alkali strength possible.
The relationship α 1-A and α 1-B determined as described above (approximate expression $y = A \times e^{Bx}$ obtained from Figs. 1-A and B), the alkali strength and the correction factor of electroconductivity (Fig. 2) were inserted into a program of a microcomputer of an automatic developing machine. The computer was programmed so that the amount of the replenisher can be controlled on the basis of the results of the determination of the development inhibitor concentration and electroconductivity
In replenishing system 1, the replenishment was as described below. In replenishing system 2, the amount of the replenisher in replenishing system 1 was controlled with the above-described device and program.
The amount of the replenisher was calculated according to the formulae given below. A (a correct alkali strength for satisfying the formula α) and a (correct inhibitor concentration) were as follows:

$$A=(VtxC+VsXB)/(Vt+Vs) \qquad ①$$

$$a=(Vtxc+VsXb)/(Vt+Vs) \qquad ②$$

wherein B represents alkali strength of the replenisher, C represents the alkali strength before the replenishment, b represents the concentration (g/L) of the development inhibitor in the replenisher, c represents the concentration (g/L) of the development inhibitor before the replenishment, Vt represents the amount (L) of the developer in the developing tank, and Vs represents the amount (L) of the replenisher to be supplied.
The amount (Vs) of the replenisher to be added to satisfy the above formulae ① and ② was calculated The program was such that the amount of the replenisher thus calculated was to be replenished.

<Replenishing system 1>

With the automatic replenishing device, the developing replenisher b1 was replenished in an amount of 35 ml per $m^2$ of the lithographic printing plate precursor, 130 ml per hour in the automatic developing device and 20 ml per hour of the stopping into the development tank.
A contact print image was formed on each of many lithographic printing plate precursors 1 to 4 with Trendsetter of Creo Co. under conditions of beam strength of 4 W and drum-rotating speed of 150 rpm and exposed to form the image.
Developer a1 was fed into an immersion type developing tank of an automatic developing machine (improved PS Processor LP940H, Fuji Photo Film Co., Ltd.) and heated to 30°C to develop the images of the lithographic printing plate precursors. In the second bath (washing tank), tap water was automatically fed to wash the lithographic printing plate precursor. In the third bath (finishing mixture tank), 4 liters of a finishing solution obtained by diluting FG-1 (Fuji

Photo Film Co., Ltd.) to a concentration of 1/2 with tap water was fed.

1000 sheets were processed while the amount of the replenisher was controlled by the replenishing systems 1 and 2 described in Example 1. The solubility of the non-image regions of the lithographic printing plate precursors 1 to 4 in the alkaline developer and also the solution resistance of the imaged regions to the alkaline developer were macroscopically evaluated on the basis of the standards described below. The results of the evaluation are shown in Tables 2 and 3.

Comparative Example 1

The lithographic printing plate precursors 1 and 3 were processed in the same manner as that of Example 1 except that only replenishing system 1 was used.

[Solubility of non-imaged regions]

○: The film did not remain at all in the exposed regions.
×: The film partially remained in the exposed regions.

[Solution resistance of imaged regions]

○: The unexposed regions were not dissolved at all in the alkaline developer.
Δ: The unexposed regions were only slightly dissolved in the alkaline developer and the image density was slightly lowered.
× : The unexposed regions were partially dissolved in the alkaline developer and the image density was lowered.

Table2

| Positive-working lithographic printing plate precursors 1 and 2 | | | | |
|---|---|---|---|---|
| Number of processed plates | Ex. 1 (precursors 1 and 2) | | Comp. Ex. 1 (precursor 1) | |
| | Developing property in non-image regions | Remaining film in image-regions | Developing property in non-image regions | Remaining film in image-regions |
| 1 | ○ | ○ | ○ | ○ |
| 50 | ○ | ○ | ○ | ○ |
| 100 | ○ | ○ | ○ | Δ |
| 150 | ○ | ○ | ○ | Δ |
| 200 | ○ | ○ | ○ | Δ |
| 300 | ○ | ○ | ○ | × |
| 400 | ○ | ○ | ○ | × |
| 500 | ○ | ○ | ○ | × |
| 600 | ○ | ○ | ○ | × |
| 700 | ○ | ○ | ○ | × |
| 800 | ○ | ○ | ○ | × |
| 900 | ○ | ○ | ○ | × |
| 1000 | ○ | ○ | ○ | × |

Table 3

| Positive-working lithographic printing plate precursors 3 and 4 | | | | |
|---|---|---|---|---|
| Number of processed plates | Ex 1. (precursors 3 and 4) | | Comp. Ex. 1 (precursor 3) | |
| | Developing property in non-image regions | Remaining film in image-regions | Developing property in non-image regions | Remaining film in image-regions |
| 1 | ○ | ○ | ○ | ○ |
| 50 | ○ | ○ | ○ | ○ |
| 100 | ○ | ○ | ○ | ○ |
| 150 | ○ | ○ | ○ | Δ |
| 200 | ○ | ○ | ○ | Δ |
| 300 | ○ | ○ | ○ | Δ |
| 400 | ○ | ○ | ○ | Δ |
| 500 | ○ | ○ | ○ | × |
| 600 | ○ | ○ | ○ | × |
| 700 | ○ | ○ | ○ | × |
| 800 | ○ | ○ | ○ | × |
| 900 | ○ | ○ | ○ | × |
| 1000 | ○ | ○ | ○ | × |

It is apparent from Tables 2 and 3 that according to the present invention, excellent images can be formed without any problem in both image regions and non-image regions for at least continuous 1000 plate precursors. It was found that when about 100 plate precursors were processed a day, the stable development was possible for one or two months.

It is apparent from the results shown in Table 3 that in the course of the continuous process in the comparative example, unexposed regions were partially dissolved in the alkaline developer to lower the image density.

Example 2

[Preparation of relationship $\alpha$2]

Developers 1 to 60 were charged in the same manner as that in relationship $\alpha$ 1 except that polyethylene glycol used as the development inhibitor in the developer was replaced with polyoxyethylene lauryl ether and that potassium hydroxide used as the alkali was replaced with potassium silicate. Lithographic printing plate precursors 1 to 4 were subjected to the development process.

| Composition 1 of developers 1 to 60 | |
|---|---|
| Potassium silicate ($SiO_2/K_2O$ = 1.1) | Table 4 |
| Polyoxyethylene lauryl ether (Pionin D-1107, development inhibitor of Takemoto Oil & Fat Co. Ltd.) | Table 4 |
| Anionic surfacetnt [compound (A-3) in (2-4) in this specification] | 0.25 g/L |

Table 4

| Composition 2 of developers 1 to 60 | | | | | |
|---|---|---|---|---|---|
| | Conc. of development inhibitor (g/L) | Conc. of potassium silicate (mass%) | | Conc. of development inhibitor (g/L) | Conc. of potassium silicate (mass%) |
| 1 | 0.05 | 3 | 31 | 0.3 | 4.5 |
| 2 | 0.10 | 3 | 32 | 0.4 | 4.5 |
| 3 | 0.15 | 3 | 33 | 0.6 | 4.5 |
| 4 | 0.20 | 3 | 34 | 0.8 | 4.5 |
| 5 | 0.25 | 3 | 35 | 0.10 | 5 |
| 6 | 0.3 | 3 | 36 | 0.15 | 5 |
| 7 | 0.4 | 3 | 37 | 0.20 | 5 |
| 8 | 0.05 | 3.5 | 38 | 0.25 | 5 |
| 9 | 0.10 | 3.5 | 39 | 0.3 | 5 |
| 10 | 0.15 | 3.5 | 40 | 0.4 | 5 |
| 11 | 0.20 | 3.5 | 41 | 0.6 | 5 |
| 12 | 0.25 | 3.5 | 42 | 0.8 | 5 |
| 13 | 0.3 | 3.5 | 43 | 0.10 | 5.5 |
| 14 | 0.4 | 3.5 | 44 | 0.15 | 5.5 |
| 15 | 0.6 | 3.5 | 45 | 0.20 | 5.5 |
| 16 | 0.8 | 3.5 | 46 | 0.25 | 5.5 |
| 17 | 0.05 | 4 | 47 | 0.3 | 5.5 |
| 18 | 0.10 | 4 | 48 | 0.4 | 5.5 |
| 19 | 0.15 | 4 | 49 | 0.6 | 5.5 |
| 20 | 0.20 | 4 | 50 | 0.8 | 5.5 |
| 21 | 0.25 | 4 | 51 | 0.20 | 6 |
| 22 | 0.3 | 4 | 52 | 0.25 | 6 |
| 23 | 0.4 | 4 | 53 | 0.3 | 6 |
| 24 | 0.6 | 4 | 54 | 0.4 | 6 |
| 25 | 0.8 | 4 | 55 | 0.6 | 6 |
| 26 | 0.05 | 4.5 | 56 | 0.8 | 6 |
| 27 | 0.10 | 4.5 | 57 | 0.20 | 6.5 |
| 28 | 0.15 | 4.5 | 58 | 0.3 | 6.5 |
| 29 | 0.20 | 4.5 | 59 | 0.4 | 6.5 |
| 30 | 0.25 | 4.5 | 60 | 0.6 | 6.5 |

The relationship $\alpha$ 2-A between the development inhibitor concentration and alkali strength obtained with lithographic printing plate precursor 1 is shown in Fig. 3-A.

The relationship $\alpha$ 2-B between the development inhibitor concentration and alkali strength obtained with lithographic printing plate precursor 3 is shown in Fig. 3-B.

The lithographic printing plate precursor 2 is different from the lithographic printing plate precursor 1 in only the substrate and also the lithographic printing plate precursor 4 is different from the lithographic printing plate precursor 3 in only the substrate. Therefore, relationship $\alpha$ 2-A can be applied to the lithographic printing plate precursor 2 and

also relationship α 2-B can be applied to the lithographic printing plate precursor 4. The relationship between the development inhibitor concentration (y) and the alkali strength (x) exponentially changes and it can be represented by the following approximate expression:

$$y = A \times e^{Bx}.$$

In the relationship α 2-Awhich can be applied to the plate precursors 1 and 2, Ais $8 \times 10^{-144}$ and B is 25.28. In the relationship α 1-B which can be applied to the plate precursors 3 and 4, Ais $3 \times 10^{-299}$ and B is 52.88.

Separately from the above-described mixtures, an alkaline developer a2 and an alkaline replenisher b2 were prepared.

[Composition of alkaline developer a2]

| 4 % aqueous potassium silicate solution ($SiO_2KO_2$ = 1.1) | |
|---|---|
| Polyoxyethylene lauryl ether (Pionin D-1107, development inhibitor of Takemoto Oil & Fat Co. Ltd.) | 0.25 g/L |
| Anionic surfactant [compound (A-3) in (2-4) in this specification] | 0.25 g/L |
| Laurylcarboxybetaine (Amorgen K of Dai-ichi Kogyo Seiyaku Co., Ltd.) | 0.1 g/L |

[Composition of replenisher b2]

| 4.5 % aqueous potassium silicate solution ($SiO_2/KO_2$ = 1.1) | |
|---|---|
| Polyoxyethylene lauryl ether (Pionin D-1107, development inhibitor of Takemoto Oil & Fat Co. Ltd) | 0.3 g/L |
| Anionic surfactant [compound (A-3) in (2-4) in this specification] | 0.3 g/L |
| Laurylcarboxybetaine (Amorgen K of Dai-ichi Kogyo Seiyaku Co., Ltd.) | 0.1 g/L |

For determining the correction factor in the determination of a change in the alkali strength by the electroconductivity, carbon dioxide gas was blown into the developer a2 and replenisher b2 and the relationship between the alkali strength and the electroconductivity was determined. The alkali strength was determined with a pH meter having glass electrodes. The lithographic printing plate precursor 1 was dissolved in the developer a2 and the replenisher b2, and the relationship between the alkalinity and the electroconductivity was determined The relationship between the alkalinity (x, $[OH^-]$ concentration, pH = -log ($10^{-14}/[OH^-]$)) and electroconductivity (y) and also the correction factor are shown in Fig. 4.

Evaluation of development process

The same development process as that of Example 1 was repeated except that the relationship between α 2-A and B (approximate expression: $y = A \times e^{Bx}$ determined from Figs. 3-A and B) and the correction factor (Fig. 4) of the alkali strength and the electroconductivity were employed and also that the replenishing systems 1 and 2 were employed for the replenishment. The solubility of the non-image regions of the lithographic printing plate precursors 1 to 4 in the alkaline developer and also the solution resistance of the imaged regions to the alkaline developer were macroscopically evaluated on the same basis as that in Example 1. The results of the evaluation are shown in Tables 5 and 6.

Comparative Example 2

Lithographic printing plate precursors 1 and 3 were processed in the same manner as that of Example 2 except that only replenishing system 1 was utilized.

Table 5

| Positive-working lithographic printing plate precursors 1 and 2 | | | | |
|---|---|---|---|---|
| Number of processed plates | Ex. 2 (precursors 1 and 2) | | Comp. Ex. 2 (precursor 1) | |
| | Developing property in non-image regions | Remaining film in image-regions | Developing property in non-image regions | Remaining film in image-regions |
| 1 | ○ | ○ | ○ | ○ |
| 50 | ○ | ○ | ○ | ○ |
| 100 | ○ | ○ | ○ | Δ |
| 150 | ○ | ○ | ○ | Δ |
| 200 | ○ | ○ | ○ | Δ |
| 300 | ○ | ○ | ○ | × |
| 400 | ○ | ○ | ○ | × |
| 500 | ○ | ○ | ○ | × |
| 600 | ○ | ○ | ○ | × |
| 700 | ○ | ○ | ○ | × |
| 800 | ○ | ○ | ○ | × |
| 900 | ○ | ○ | ○ | × |
| 1000 | ○ | ○ | ○ | × |

Table 6

| Positive-working lithographic printing plate precursors 3 and 4 | | | | |
|---|---|---|---|---|
| Number of processed plates | Ex. 2 (precursors 3 and 4) | | Comp. Ex. 2 (precursor 3) | |
| | Developing property in non-image regions | Remaining film in image-regions | Developing property in non-image regions | Remaining film in image-regions |
| 1 | ○ | ○ | ○ | ○ |
| 50 | ○ | ○ | ○ | ○ |
| 100 | ○ | ○ | ○ | ○ |
| 150 | ○ | ○ | ○ | Δ |
| 200 | ○ | ○ | ○ | Δ |
| 300 | ○ | ○ | ○ | Δ |
| 400 | ○ | ○ | ○ | Δ |
| 500 | ○ | ○ | ○ | × |
| 600 | ○ | ○ | ○ | × |
| 700 | ○ | ○ | ○ | × |
| 800 | ○ | ○ | ○ | × |
| 900 | ○ | ○ | ○ | × |
| 1000 | ○ | ○ | ○ | × |

It is apparent from Tables 5 and 6 that according to the present invention, excellent images can be formed without any problem in both image regions and non-image regions for at least continuous 1000 plate precursors. It was found that when about 100 plate precursors were processed a day, the stable development was possible for one or two months.

It is apparent from the results shown in Table 6 that in the course of the continuous process in Comparative Example 2, unexposed regions were partially dissolved in the alkaline developer to lower the image density.

Example 3

[Preparation of relationship α3]

A developer-sampling device, an optical cell, an infrared light source and a detector were placed in the developing tank of the automatic developing machine used in Example 1 to determine the absorbance of the alkaline developer. The absorbance was determined at a wave length of 830 nm due to an infrared-absorbing dye in the lithographic printing plate precursor. Further the concentration of the development inhibitor was determined with a device for determining the concentration of the development inhibitor in the automatic developing machine used in Example 1. Thus it was confirmed that the concentration of the development inhibitor can be determined by determining the absorbance. Therefore, the relationship α 1-A and B were employed as the relationship *α3.*

A change in the alkali strength was determined on the basis of the electroconductivity in the same manner as that in Example 1. Namely, the alkali strength was determined from the electroconductivity by using the correction factor of alkali strength and electroconductivity (Fig. 2).

Evaluation of development process

The same development process as that of Example 1 was repeated except that the density of the development inhibitor was determined by determining the absorbance as described above. The solubility of the non-image regions of the lithographic printing plate precursors 1 to 4 in the alkaline developer and also the solution resistance of the imaged regions to the alkaline developer were macroscopically evaluated on the same basis as that in Example 1. The results of the evaluation are shown in Tables 7 and 8.

Comparative Example 3

Lithographic printing plate precursors 1 and 3 were processed in the same manner as that of Example 3 except that only replenishing system 1 was utilized.

Table 7

| Positive-working lithographic printing plate precursors 1 and 2 | | | | |
|---|---|---|---|---|
| Number of processed plates | Ex. 3 (precursors 1 and 2) | | Comp. Ex 3 (precursor 1) | |
| | Developing property in non-image regions | Remaining film in image-regions | Developing property in non-image regions | Remaining film in image-regions |
| 1 | ○ | ○ | ○ | ○ |
| 50 | ○ | ○ | ○ | ○ |
| 100 | ○ | ○ | ○ | Δ |
| 150 | ○ | ○ | ○ | Δ |
| 200 | ○ | ○ | ○ | Δ |
| 300 | ○ | ○ | ○ | × |
| 400 | ○ | ○ | ○ | × |
| 500 | ○ | ○ | ○ | × |
| 600 | ○ | ○ | ○ | × |
| 700 | ○ | ○ | ○ | × |

Table 7 (continued)

| Positive-working lithographic printing plate precursors 1 and 2 | | | | |
|---|---|---|---|---|
| Number of processed plates | Ex. 3 (precursors 1 and 2) | | Comp. Ex 3 (precursor 1) | |
| | Developing property in non-image regions | Remaining film in image-regions | Developing property in non-image regions | Remaining film in image-regions |
| 800 | ○ | ○ | ○ | × |
| 900 | ○ | ○ | ○ | × |
| 1000 | ○ | ○ | ○ | × |

Table 8

| Positive-working lithographic printing plate precursors 3 and 4 | | | | |
|---|---|---|---|---|
| Number of processed plates | Ex. 3 (precursors 3 and 4) | | Comp. Ex. 3 (precursor 3) | |
| | Developing property in non-image regions | Remaining film in image-regions | Developing property in non-image regions | Remaining film in image-regions |
| 1 | ○ | ○ | ○ | ○ |
| 50 | ○ | ○ | ○ | ○ |
| 100 | ○ | ○ | ○ | ○ |
| 150 | ○ | ○ | ○ | Δ |
| 200 | ○ | ○ | ○ | Δ |
| 300 | ○ | ○ | ○ | Δ |
| 400 | ○ | ○ | ○ | Δ |
| 500 | ○ | ○ | ○ | × |
| 600 | ○ | ○ | ○ | × |
| 700 | ○ | ○ | ○ | × |
| 800 | ○ | ○ | ○ | × |
| 900 | ○ | ○ | ○ | × |
| 1000 | ○ | ○ | ○ | × |

It is apparent from Tables 7 and 8 that according to the present invention, excellent images can be formed without any problem in both image regions and non-image regions for at least continuous 1000 plate precursors. It was found that when about 100 plate precursors were processed a day, the stable development was possible for one or two months.

It is apparent from the results shown in Table 8 that in the course of the continuous process in Comparative Example 3, unexposed regions were partially dissolved in the alkaline developer to lower the image density.

Example 4

A sensor for detecting the lithographic printing plate precursor was placed at the inlet of a development tank of the automatic developing machine used in Example 1 to monitor the amount of the processed precursors. Then the concentration of the development inhibitor was determined with a development inhibitor concentration meter in the automatic developing machine used in Example 1 to determine the relationship between the amount of the processed precursors and the concentration of the development inhibitor. The alkali developer a1 was previously fed into the

development tank. The replenisher b1 was added by the replenishing system 1 described in Example 1. The developing process was conducted while the amount of the plate precursors to be processed was kept at 10 $m^2$, 20 $m^2$, 30 $m^2$, 50 $m^2$, 100 $m^2$ and 200 $m^2$ a day Under these conditions, the developing effect inclined to be enhanced. After the completion of the development process, the inhibitor concentration in the developer was determined by using nonionic surfactant electrodes. The relationship between the amount of the processed products and the inhibitor concentration is shown in Fig. 5.

The relationship between the processing amount and the concentration of the development inhibitor is as shown in Fig. 5. It was thus confirmed that the concentration of the development inhibitor can be determined by measuring the processed amount. Therefore, the relationship $\alpha$ 1-A and B were used for the relationship $\alpha 4$.

A change in the alkali strength was determined on the basis of the electroconductivity as in Example 1. Namely, the alkali strength was determined from the electroconductivity by using the correction factor of alkali strength and electroconductivity (Fig. 2).

Evaluation of development process

The same development process as that of Example 1 was repeated except that the relationship $\alpha$ 1-A and B (approximate expression: $y = A \times e^{Bx}$ determined from Figs. 1-A and B) and the correction factor (Fig. 2) of the alkali strength and the electroconductivity were employed and also that the replenishing system 3 was employed for the replenishment. The solubility of the non-image regions of the lithographic printing plate precursors 1 to 4 in the alkaline developer and also the solution resistance of the imaged regions to the alkaline developer were macroscopically evaluated on the same basis as that in Example 1. The results of the evaluation are shown in Tables 9 and 10.

Comparative Example 4

Lithographic printing plate precursors 1 and 3 were processed in the same manner as that of Example 1 except that only replenishing system 1 was utilized.

<Replenishing system 3>

A sensor for detecting the precursors was placed at the inlet of a development tank to monitor the amount of the processed precursors. Also an electroconductivity sensor was also arranged to detect the change of the alkali strength. The monitored amount was inserted into Fig. 5 to determine the inhibitor concentration. Further the alkali strength was determined with an electroconductivity sensor and the amount of the replenisher b1 was controlled so as to satisfy the relationship $\alpha$ 1-A and B.

Table 9

| Positive-working lithographic printing plate precursors 1 and 2 | | | | |
|---|---|---|---|---|
| Number of processed plates | Ex. 4 (precursors 1 and 2) | | Comp. Ex. 4 (precursor 1) | |
| | Developing property in non-image regions | Remaining film in image-regions | Developing property in non-image regions | Remaining film in image-regions |
| 1 | ○ | ○ | ○ | ○ |
| 50 | ○ | ○ | ○ | ○ |
| 100 | ○ | ○ | ○ | Δ |
| 150 | ○ | ○ | ○ | Δ |
| 200 | ○ | ○ | ○ | Δ |
| 300 | ○ | ○ | ○ | × |
| 400 | ○ | ○ | ○ | × |
| 500 | ○ | ○ | ○ | × |
| 600 | ○ | ○ | ○ | × |
| 700 | ○ | ○ | ○ | × |

Table 9 (continued)

| Positive-working lithographic printing plate precursors 1 and 2 | | | | |
|---|---|---|---|---|
| Number of processed plates | Ex. 4 (precursors 1 and 2) | | Comp. Ex. 4 (precursor 1) | |
| | Developing property in non-image regions | Remaining film in image-regions | Developing property in non-image regions | Remaining film in image-regions |
| 800 | ○ | Δ | ○ | × |
| 900 | ○ | Δ | ○ | × |
| 1000 | ○ | Δ | ○ | × |

Table 10

| Positive-working lithographic printing plate precursors 3 and 4 | | | | |
|---|---|---|---|---|
| Number of processed plates | Ex. 4 (precursors 3 and 4) | | Comp. Ex. 4 (precursor 3) | |
| | Developing property in non-image regions | Remaining film in image-regions | Developing property in non-image regions | Remaining film in image-regions |
| 1 | ○ | ○ | ○ | ○ |
| 50 | ○ | ○ | ○ | ○ |
| 100 | ○ | ○ | ○ | ○ |
| 150 | ○ | ○ | ○ | Δ |
| 200 | ○ | ○ | ○ | Δ |
| 300 | ○ | ○ | ○ | Δ |
| 400 | ○ | ○ | ○ | Δ |
| 500 | ○ | ○ | ○ | × |
| 600 | ○ | ○ | ○ | × |
| 700 | ○ | ○ | ○ | × |
| 800 | ○ | ○ | ○ | × |
| 900 | ○ | ○ | ○ | × |
| 1000 | ○ | Δ | ○ | × |

It is apparent from Tables 9 and 10 that according to the present invention, excellent images can be continuously formed without any problem in both image regions and non-image regions for at least 700 plate precursors and thus the stable development was possible for a long time.

It is apparent from the results shown in Table 10 that in the course of the continuous process in Comparative Example 4, unexposed regions were partially dissolved in the alkaline developer to lower the image density.

Effects of the Invention

In the development of a positive-working lithographic printing plate precursor with the alkaline developer containing the development inhibitor according to the present invention, the development process is carried out while the replenisher containing the development inhibitor is fed, the concentration of the development inhibitor in the developer in the developing tank is determined and the amount of the replenisher is controlled on the basis of the determined concentration so as to suitably control the developing property.

It is thus made possible to add the development inhibitor which exerts a great influence on the developing

property so as to suitably control the concentration of the development inhibitor in the developer. For example, when a lithographic printing plate precursor having a positive-working photosensitive layer for infrared laser is continuously processed, the image of a constant quality having an excellent contrast can be formed for a long period of time without damaging the image regions. Thus, the excellent effects can be obtained by the present invention.

## Claims

1. A method for developing a lithographic printing plate precursor by using an alkaline developing solution containing a development inhibitor, said lithographic printing plate precursor comprising a substrate and an image forming layer thereon which comprises an alkali soluble resin,
said method comprising the steps of:

    (1) predetermining a relationship $\alpha$ between the concentration of said development inhibitor and the alkalinity of said alkaline developing solution under appropriate development conditions;
    (2) measuring both said concentration of said development inhibitor and said alkalinity of said alkaline developing solution at the time of developing said precursor; and
    (3) controlling said concentration of said development inhibitor and/or said alkalinity in order to satisfy said relationship $\alpha$.

2. The method of claim 1, wherein the concentration of the development inhibitor in the alkaline developing solution is measured by one of the means selected from the group consisting of the following means (a) to (d):

    (a) one or more devices selected from an electrochemical analyzer, a light spectrophotometric analyzer, chromatography, a foaming mesuring device and a combination thereof;
    (b) a means for determining the concentration of the alkali soluble resin in said alkaline developing solution;
    (c) a means for determining the processed amount of said lithographic printing plate precursor; and
    (d) a combination of (a) to (c).

3. The method of claim 1, wherein the alkalinity of the alkaline developing solution is measured by determining the electric conductivity of the alkaline developing solution.

4. The method of claim 1, wherein said image forming layer comprises an infrared absorbable dye, and wherein said lithographic printing plate precursor is a heat-sensitive positive-working lithographic printing plate precursor imagewise-exposed by an infrared laser.

5. The method of claim 1, wherein the relationship $\alpha$ is represented by the following formula.

$$y=6 \times 10^{-25} \times e^{4.16x}$$

(wherein x represents the alkalinity of said alkaline developing solution under appropriate development conditions and y represents the concentration of said development inhibitor (g/l) of said alkaline developing solution under appropriate development conditions.)

6. The method of claim 1, wherein the relationship $\alpha$ is the following formula.

$$y=1 \times 20^{-71} \times e^{12.36x}$$

(wherein x represents the alkalinity of said alkaline developing solution under appropriate development conditions and y represents the concentration of said development inhibitor (g/l) of said alkaline developing solution under appropriate development conditions.)

7. A system for developing a lithographic printing plate precursor which comprises an alkali soluble resin having a substrate and an image forming layer thereon, wherein said lithographic printing plate precursor is developed by an alkaline developing solution containing a development inhibitor, and wherein said system comprisies:

(1) a means for predetermining a relationship $\alpha$ between the concentration of said development inhibitor and the alkalinity of said alkaline developing solution under appropriate development conditions;
(2) a means for measuring both the concentration of said development inhibitor and the alkalinity of said alkaline developing solution at the time of developing said precursor; and
(3) a means for controlling said concentration of said development inhibitor and/or said alkalinity in order to satisfy said relationship $\alpha$.

**8.** The system of claim 7, wherein the concentration of the development inhibitor in the alkaline developing solution is measured by the means selected from the group consisting of the following means (a) to (d):

(a) one or more devices selected from an electrochemical analyzer, a light spectrophotometric analyzer, chromatography, a foaming mesuring device and a combination thereof;
(b) a means for determining the concentration of the alkali soluble resin in said alkaline developing solution;
(c) a means for determining the processed amount of said lithographic printing plate precursor; and
(d) a combination of means (a) to (c).

**9.** The system of claim 7, wherein the alkalinity of the alkaline developing solution is measured by determining the electric conductivity of the alkaline developing solution.

**10.** The system of claim 7, wherein said image forming layer comprises an infrared absorbable dye, and wherein said lithographic printing plate precursor is a heat-sensitive positive-working lithographic printing plate precursor imagewise-exposed by an infrared laser.

**11.** The system of claim 7, wherein the relationship $\alpha$ is represented by the following formula.

$$y=6 \times 10^{-25} \times e^{4.16x}$$

(wherein x represents the alkalinity of said alkaline developing solution under appropriate development conditions and y represents the concentration of said development inhibitor (g/l) of said alkaline developing solution under appropriate development conditions.)

**12.** The system of claim 7, wherein the relationship $\alpha$ is represented by the following formula.

$$y=1 \times 20^{-71} \times e^{12.36x}$$

(wherein x represents the alkalinity of said alkaline developing solution under appropriate development conditions and y represents the concentration of said development inhibitor (g/l) of said alkaline developing solution under appropriate development conditions.)

**13.** A system for developing a lithographic printing plate precursor which comprises an alkali soluble resin having a substrate and an image forming layer thereon, said lithographic printing plate precursor being developed by an alkaline solution containing a development inhibitor, wherein said system comprises a device controlling the concentration of the development inhibitor and/or the alkalinity in order to satisfy a relationship $\alpha$ which is determined from a relationship between the concentration of said development inhibitor and alkalinity in said alkaline developing solution under appropriate development conditions.

**14.** The system of claim 13, wherein the concentration of the development inhibitor in the alkaline developing solution is measured by the means selected from the group consisting of the following means (a) to (d):

(a) one or more devices selected from an electrochemical analyzer, a light spectrophotometric analyzer, chromatography, a foaming mesuring device and a combination thereof;
(b) a means for determining the concentration of the alkali soluble resin in said alkaline developing solution;
(c) a means for determining the processed amount of said lithographic printing plate precursor; and
(d) a combination of means (a) to (c).

**15.** The system of claim 13, wherein the alkalinity of the alkaline developing solution is measured by determining the

electric conductivity of the alkaline developing solution.

**16.** The system of claim 13, wherein said image forming layer comprises an infrared absorbable dye, and wherein said lithographic printing plate precursor is a heat-sensitive positive-working lithographic printing plate precursor imagewise-exposed by an infrared laser.

**17.** The system of claim 13, wherein the relationship $\alpha$ is represented by the following formula.

$$y=6 \times 10^{-25} \times e^{4.16x}$$

(wherein x represents the alkalinity of said alkaline developing solution under appropriate development conditions and y represents the concentration of said development inhibitor (g/l) of said alkaline developing solution under appropriate development conditions.)

**18.** The system of claim 13, wherein the relationship $\alpha$ is represented by the following formula.

$$y = 1 \times 20^{-71} \times e^{12.36x}$$

(wherein x represents the alkalinity of said alkaline developing solution under appropriate development conditions and y represents the concentration of said development inhibitor (g/l) of said alkaline developing solution under appropriate development conditions.)

# FIG. 1-A

Relationship α1-A of precursor 1

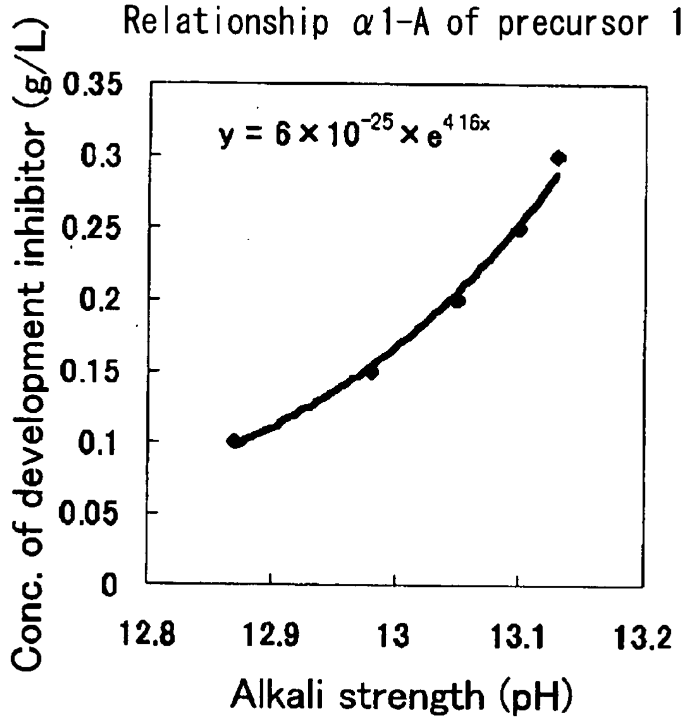


# FIG. 1-B

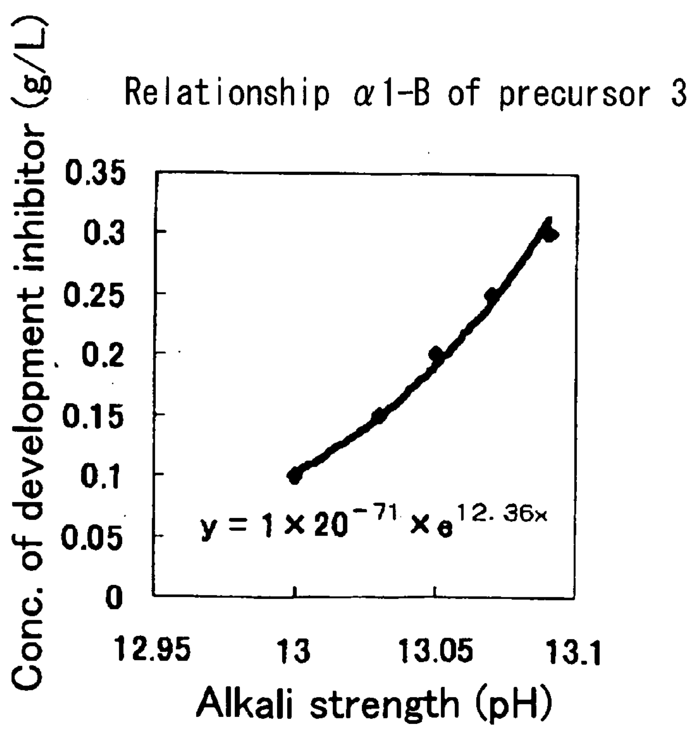

FIG. 2

The relationship between the alkalinity ([OH-] concentration) and electroconductivity

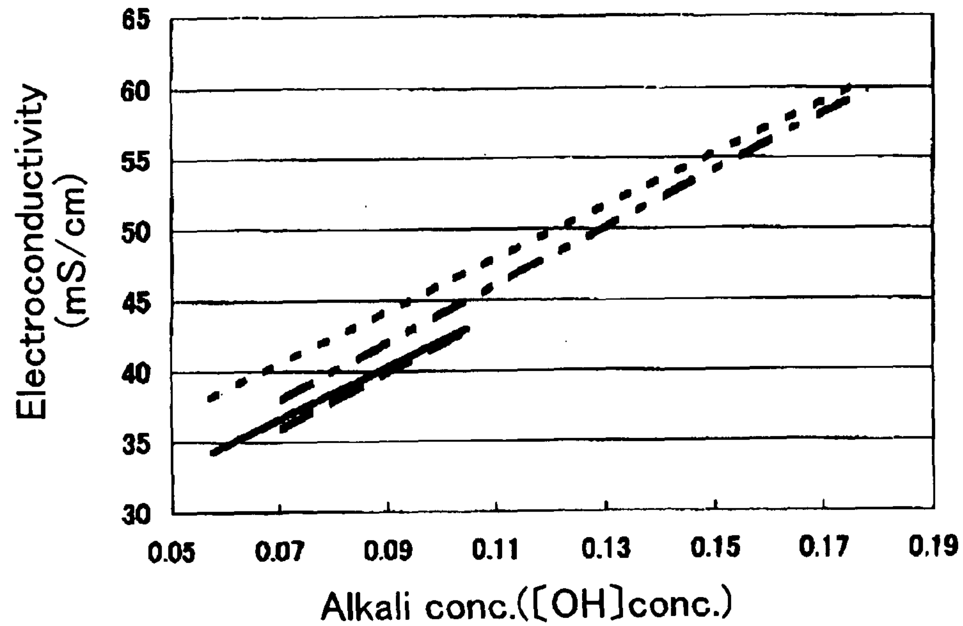


wherein:

| | | (Correction factor) |
|---|---|---|
| - - - - - - - - | : carbon dioxide ($CO_2$) was blown into replenisher b1 | y=186x+27 |
| —·—·—·— | : plate precursor 1 was dissolved in replenisher b1 | y=204x+24 |
| ———— | : carbon dioxide ($CO_2$) was blown into developer a1 | y=184x+24 |
| — — — — — | : plate precursor 1 was dissolved in replenisher a1 | y=206x+21 |

FIG. 3-A

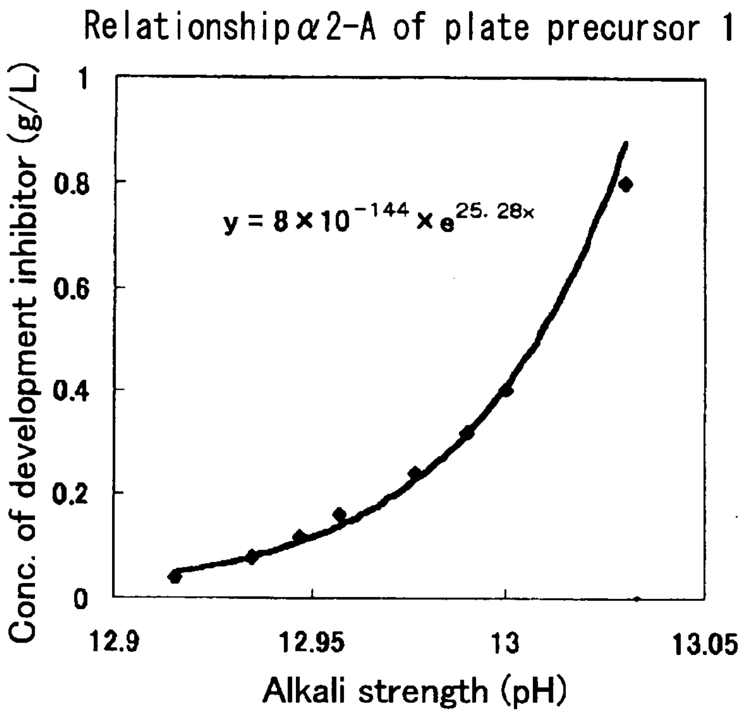
Relationship α2-A of plate precursor 1
y = 8×10^-144 × e^25.28x
Conc. of development inhibitor (g/L)
1
0.8
0.6
0.4
0.2
0
12.9
12.95
13
13.05
Alkali strength (pH)

FIG. 3-B

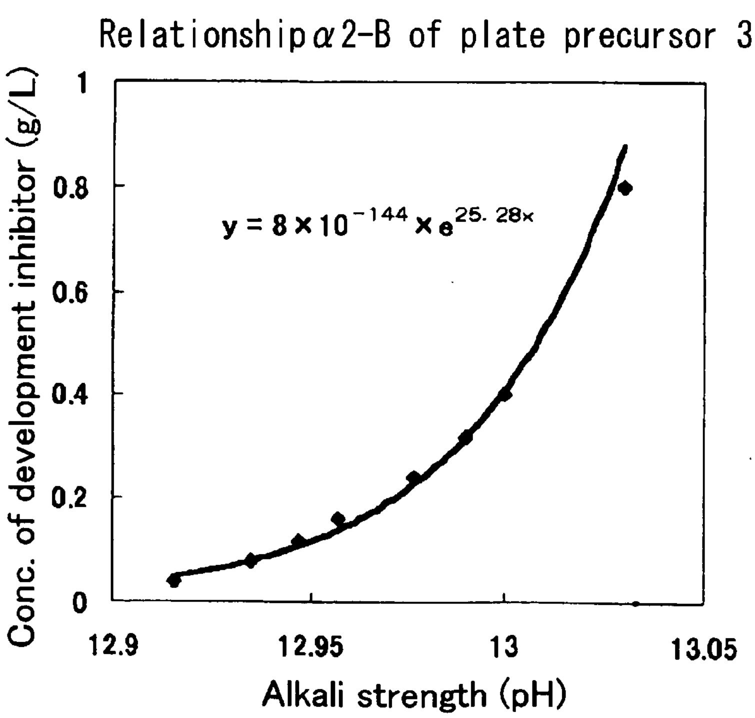
Relationship α2-B of plate precursor 3
y = 8×10^-144 × e^25.28x
Conc. of development inhibitor (g/L)
1
0.8
0.6
0.4
0.2
0
12.9
12.95
13
13.05
Alkali strength (pH)

FIG. 4

The relationship between the alkalinity ([OH-] concentration) and electroconductivity

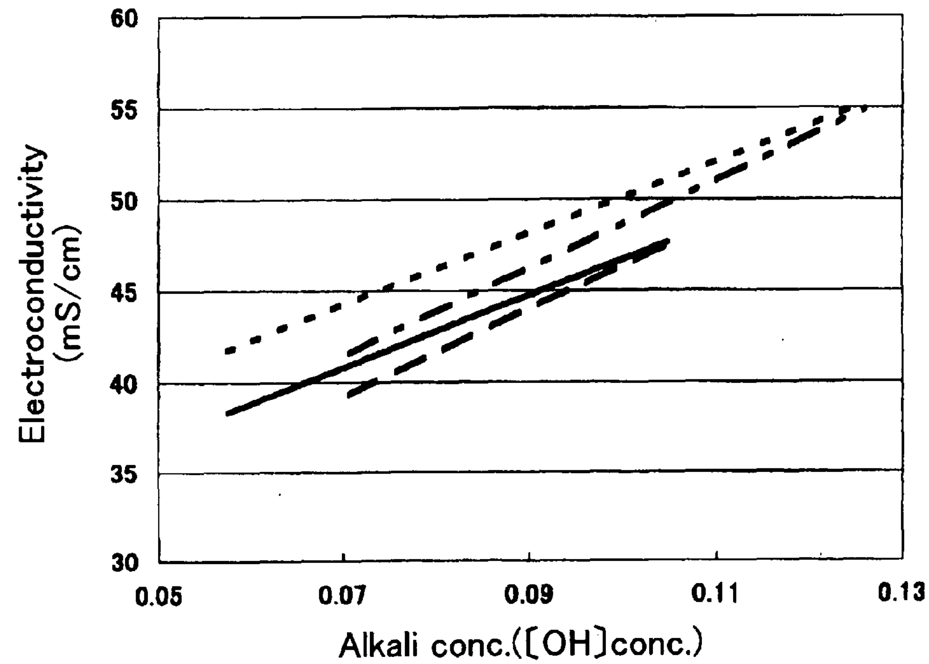


wherein:

| | | (Correction factor) |
|---|---|---|
| - - - - - - - | : carbon dioxide ($CO_2$) was blown into replenisher b2 | y=198x+30 |
| —·—·—·— | : plate precursor 1 was dissolved in replenisher b2 | y=242x+24 |
| ——— | : carbon dioxide ($CO_2$) was blown into developer a2 | y=197x+27 |
| — — — — | : plate precursor 1 was dissolved in replenisher a2 | y=241x+22 |

FIG. 5

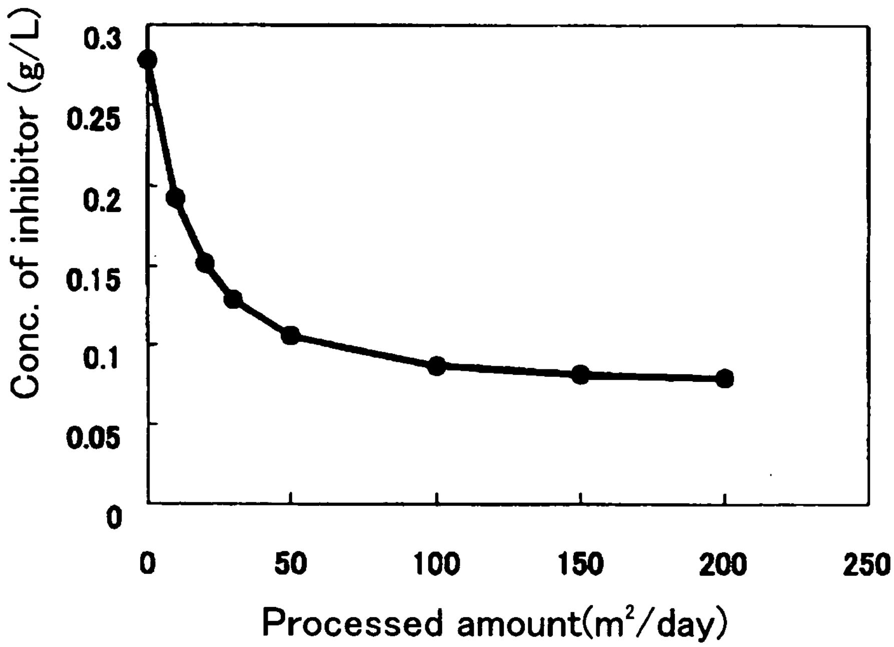
Conc. of inhibitor (g/L)
0.3
0.25
0.2
0.15
0.1
0.05
0
0
50
100
150
200
250
Processed amount(m²/day)